# EUROPEAN PATENT SPECIFICATION

(11) **EP 4 485 125 B1**
(45) Date of publication and mention of the grant of the patent: **01.04.2026**
(21) Application number: 24181843.4
(22) Date of filing: 13.06.2024
(51) Int. Cl.: G06F 1/16, H10K 77/10, H10K 102/00

(54) **DISPLAY APPARATUS**
ANZEIGEGERÄT
APPAREIL D'AFFICHAGE

(30) Priority: 29.06.2023 KR 20230084417
(43) Date of publication of application: 01.01.2025
(73) Proprietor: LG Display Co., Ltd., Seoul 07336 (KR)
(72) Inventor: KIM, Myeong Jun, 10845 (KR)
(74) Representative: Ter Meer Steinmeister & Partner

(56) References cited:
- CN-A- 116 209 307
- US-A1- 2018 092 166
- US-A1- 2020 303 678

## Description

### BACKGROUND

### Field

Embodiments of the present disclosure relate to a display apparatus, and more particularly, to a display apparatus which includes a protection member.

### Description of Related Art

A modem display apparatus capable of displaying various information and interacting with a user who views the information is required to have various sizes, various shapes and various functions.

Such a display apparatus includes a liquid crystal display apparatus (LCD), an electrophoretic display apparatus (FPD) or a light emitting diode display apparatus (LED).

As the display apparatus is used in a variety of ways, the design of the display apparatus is becoming more diverse to reduce the area of a non-display area where an image is not displayed, for the aesthetic feeling of a user.

To this end, research is being conducted to apply a flexible material to a substrate of the display apparatus so as to allow various parts of the display apparatus to be bent using the flexible properties of the flexible substrate.

There is a problem that cracking and delamination of a display panel occur in a bending area thereof due to external impacts applied to the bending area of the flexible substrate.

The cracking and delamination of the display panel may interfere with image driving of a display area, causing abnormal image display problems. Although various studies are being conducted to prevent cracking and delamination in the bending area where the display panel of the display apparatus is bent, these are still insufficient, and thus, development is keenly needed.

US 2018/0092166 A1 describes a display apparatus, comprising: a base layer including a display area and a non-display area; the non-display area including a first area, second area and a bend allowed area between the first area and the second area; an encapsulation layer located in the display area and at least a portion of the first area; an optical film on the display area, extending into the at least portion of first area; a drive chip below the second area; a plurality of wires routed from the first area to the second area; and a coating layer covering the bend allowed area and in contact with an edge of the optical film. In an example, a region over the bend allowance section is coated with a first type of micro-coating layer. Another type of micro-coating layer is coated in the regions next to the region coated with the first type of micro-coating layer. A third type of micro-coating layer including one or more getter materials is provided underneath the first type of micro-coating layer and the second type of micro-coating layer.

CN 116209307 A describes a display panel that comprises a first plane area, a bending area and a second plane area. A protective film layer at least covers the bending area on the display side of the display panel. The protective film layer comprises a first protective layer and a second protective layer. In an example, the second protective layer comprises a cured adhesive layer and an extended film layer.

US 2020/0303678 A1 describes a display device that includes a substrate including a display area including a plurality of pixels and a non-display area positioned around the display area and including a bending portion. A protection layer entirely covers one surface of the bending portion and is positioned outermost of the substrate.

### SUMMARY

The invention is indicated in the independent claim. Embodiments are indicated in the dependent claims.

An object to be achieved by the present disclosure is to provide a display apparatus which includes a plurality of protection members disposed on at least an outer part of a bending area of a display panel of the display apparatus to minimize or at least reduce the breakage of the display apparatus due to external impacts.

Another object to be achieved by the present disclosure is to provide a display apparatus which includes a plurality of protection members made of different materials to minimize a change in physical properties likely to occur during a processing process of curing each protection member.

Still another object to be achieved by the present disclosure is to provide a display apparatus which has improved reliability by ensuring that a signal is normally transferred through preventing or at least reducing cracking and delamination of a display panel of the display apparatus.

It should be noted that objects of the present disclosure are not limited to those described above and other objects of the present disclosure will be apparent to those skilled in the art from the following descriptions. At least one of these objects is solved by the subject-matter of the independent claims. Refinements and advantageous embodiments are disclosed by the respective dependent claims.

A display apparatus according to an embodiment of the present disclosure may include a display panel including a plurality of non-bending areas and a bending area disposed between the plurality of non-bending areas; a first protection member disposed on the display panel at least in the bending area; a second protection member disposed on the first protection member; and a third protection member disposed on the second protection member.

Embodiments of the present disclosure may include one or more of the following optional features:

At least one end of the first protection member may be disposed on the display panel in one of the at least two non-bending areas or two ends of the first protection member may be disposed on the display panel in the at least two non-bending areas, respectively.

The second protection member may cover at least one end of the first protection member, in particular a side surface of the at least one end of the first protection member. The second protection member may cover a side surface of the end of the first protection member disposed on the display panel in the second non-bending area of the at least two non-bending areas.

One end of the second protection member may contact at least a portion of the display panel. At least one end of the second protection member is disposed in one of the at least two non-bending areas, or two ends of the second protection member may be disposed in the at least two non-bending areas, respectively.

The first protection member and the second protection member may be disposed along the bending area. The third protection member may cover a side surface of the bending area.

The second protection member and the third protection member may be made of different materials.

The second protection member may be composed of or may include an ultraviolet blocking material.

The third protection member may be composed of or may include an ultraviolet transmitting material.

The first protection member and/or the third protection member may include or may be composed of resin.

The second protection member may include or may be composed of a black material.

The second protection member may include or may be composed of an adhesive material and/or may have adhesive properties.

A tensile modulus of the first protection member may be different from a tensile modulus of the third protection member.

The tensile modulus of the third protection member may be equal to or less than the tensile modulus of the first protection member.

The display apparatus may further comprise a polarizer on the display panel. The polarizer may contact one end of the first protection member and/or one end of the second protection member.

The display apparatus may further comprise a flexible film spaced apart from one end of the first protection member and/or one end of the second protection member.

The third protection member may cover the bending area and/or a portion of the plurality of non-bending areas.

The display apparatus may further comprise a front surface member contacting the third protection member. The front surface member may be disposed on a front side and/or front surface of the display panel.

The display apparatus may further comprise a support member disposed on a rear side and/or a rear surface of the display panel. The second protection member may overlap the support member. At least one end of the second protection member may overlap the support member. When the display panel is bent, in particular at the bending area, the support member may be sandwiched between the two ends of the second protection member disposed in the at least two non-bending areas, respectively.

The display panel may be or may comprise a flexible display panel.

The display panel may further include a thin film transistor and/or a light emitting element layer, the light emitting element layer including an organic material or an inorganic material.

The light emitting element layer may include a plurality of light emitting parts and a charge generation layer between the plurality of light emitting parts.

The tensile modulus of the third protection member may be greater than the tensile modulus of the first protection member.

A bending area of the display panel may correspond to an area of the display panel that can be bent and/or that is bent. The bending area may also be denoted as "bent area". A non-bending area of the display panel may correspond to an area of the display panel that cannot be bent and/or that is not bent. The non-bending area may also be denoted as" non-bent area".

In the display apparatus according to embodiments of the present disclosure, since a plurality of protection members are disposed on at least an outer part of the bending area of a display panel of the display apparatus, it is possible to minimize or at least reduce the breakage of the display apparatus due to external impacts.

Since the display apparatus according to embodiments of the present disclosure includes the plurality of protection members made of different materials, it is possible to minimize or at least reduce a change in physical properties likely to occur during a processing process of curing each protection member.

In the display apparatus according to embodiments of the present disclosure, since a signal may be normally transferred by preventing cracking and delamination of the display panel of the display apparatus, it is possible to provide the display apparatus which has improved reliability and is capable of having low power consumption.

It should be noted that effects of the present disclosure are not limited to those described above and other effects of the present disclosure will be apparent to those skilled in the art from the description of claims.

### BRIEF DESCRIPTION OF DRAWINGS

The above and other objects, features, and advantages of the present disclosure will be more clearly understood from the following detailed description, taken in conjunction with the accompanying drawings, in which:
FIG. 1 is a view showing a display apparatus according to an embodiment of the present disclosure.
FIG. 2 is a plan view of a display panel according to an embodiment of the present disclosure.
FIG. 3 is a cross-sectional view taken along the line I-I' of FIG. 2 according to an embodiment of the present disclosure.
FIG. 4 is a cross-sectional view of a display apparatus according to an embodiment of the present disclosure.
FIG. 5 is a view showing a manufacturing process of a protection member according to an embodiment of the present disclosure.
FIG. 6 is a plan view showing components disposed in a display panel according to an embodiment of the present disclosure.
FIG. 7 is a plan view showing a pixel disposition according to an embodiment of the present disclosure.
FIG. 8 is a cross-sectional view of a display panel according to an embodiment of the present disclosure.
FIG. 9 is a cross-sectional view of a light emitting part according to an embodiment of the present disclosure.

### DETAILED DESCRIPTION

Advantages and features of the present disclosure, and implementation methods thereof will be clarified through following embodiments described with reference to the accompanying drawings. The present disclosure may, however, be embodied in different forms and should not be construed as limited to the embodiments set forth herein. Rather, these embodiments are provided so that this disclosure will be thorough and complete, and will fully convey the scope of the present disclosure to those skilled in the art. Furthermore, the present disclosure is only defined by scopes of claims.

In addition, the shapes, sizes, ratios, angles, numbers, and the like illustrated in the drawings for describing embodiments of the present disclosure are merely examples, and thus, the present disclosure is not limited thereto. Like reference numerals refer to like elements throughout the present disclosure. In the following description, when the detailed description of the relevant known technology is determined to unnecessarily obscure the important point of the present disclosure, the detailed description will be omitted. The terms, such as "including", "having", "containing", and "comprising of" or the like, used herein are generally intended to allow other components to be added unless the terms are used with the term "only". Singular forms used herein are intended to include plural forms unless the context clearly indicates otherwise.

In interpreting any elements or features of the embodiments of the present disclosure, it should be considered that any dimensions and relative sizes of layers, areas and regions include a tolerance or error range even when a specific description is not conducted.

Spatially relative terms, such as "on", "over", "above", "below", "under", "beneath", "lower", "upper", "near", "close", "adjacent", or the like, used herein to describe one element or feature's relationship to another element(s) or feature(s) are generally intended to allow one or more additional elements to be interposed between the elements unless the terms, such as "directly", "immediately", or the like, are used.

Time relative terms, such as "after", "subsequent to", "next", "before", or the like, used herein to describe a temporal relationship between events, operations, or the like are generally intended to include events, cases, operations, or the like that do not occur consecutively unless the terms, such as "directly", "immediately", or the like, are used.

When the terms, such as "first", "second", or the like, are used herein to describe various elements or components, it should be considered that these elements or components are not limited thereto. These terms are merely used herein for distinguishing an element from other elements. Therefore, a first element mentioned below may be a second element in a technical concept of the present disclosure.

The terms, such as "first", "second", "A", "B", "(A)", or "(B)" may be used herein to describe one or more elements of the present disclosure. Each of the terms is not used to define essence, order, sequence, or number of an element, but is used merely to distinguish the corresponding element from another element. When it is mentioned that an element is "connected" or "coupled" to or "contacts" another element, it should be understood that an additional element may be interposed between the elements or the elements may be connected or coupled to or contact each other indirectly, as well as that the one element is connected or coupled to or contacts another element directly, unless the context clearly indicates otherwise.

It should be understood that the term "at least one" used herein can include all combinations obtained by combining one or more associated elements. For example, "at least one of a first element, a second element, and a third element" can include all combinations obtained by combining two or more of the first element, the second element, and the third element, as well as the first element, the second element, or the third element.

The term "apparatus" used herein may include a display apparatus, such as a liquid crystal module (LCM), an organic light emitting display module (OLED Module), or the like, which includes a display panel and a driver for driving the display panel. The display apparatus may include a notebook computer, a television, a computer monitor, a vehicle apparatus, an automotive apparatus, an equipment apparatus including one or more components or parts for a vehicle, a set electronic apparatus (or a set device or a set apparatus) including a mobile electronic apparatus such as a smartphone, an electronic pad, etc., which is a complete product or final product including the LCM, the OLED module, or the like.

Accordingly, the display apparatus used herein may include a display apparatus itself, such as the LCM, the OLED module, etc., and an application product including the LCM, the OLED module, etc. or a set apparatus that is an apparatus for end consumers.

In some embodiments or examples, the LCM or the OLED module including the display panel, the driver, and the like may be referred to as "display apparatus", and an electronic apparatus including the LCM or the OLED module as a complete product may be referred to as "set apparatus". For example, the display apparatus may include a display panel of a liquid crystal display (LCD) or an organic light emitting display (OLED), and a source PCB that is a controller for driving the display panel. The set apparatus may further include a set PCB that is a set controller for controlling the entire of the set apparatus, with being electrically connected to the source PCB.

All types of display panels, such as a liquid crystal display panel, an organic light emitting diode (OLED) display panel, an electroluminescent display panel, and the like, may be used as the display panel used herein. Embodiments of the present disclosure are not limited thereto. There is no limitation to a shape or a size of a display panel applied to a display apparatus according to embodiments of the present disclosure.

Features of various embodiments of the present disclosure may be partially or overall coupled to or combined with each other, and may be variously inter-operated with each other and driven technically as those skilled in the art can sufficiently understand. The embodiments of the present disclosure may be carried out independently from each other, or may be carried out together in co-dependent relationship.

Hereinafter, embodiments of the present disclosure will be described in detail with reference to the accompanying drawings. For convenience of description, a scale of each of elements illustrated in the accompanying drawings differs from a real scale, and thus, is not limited to a scale illustrated in the drawings.

Hereinafter, various embodiments of the present disclosure are described in detail with reference to the accompanying drawings.

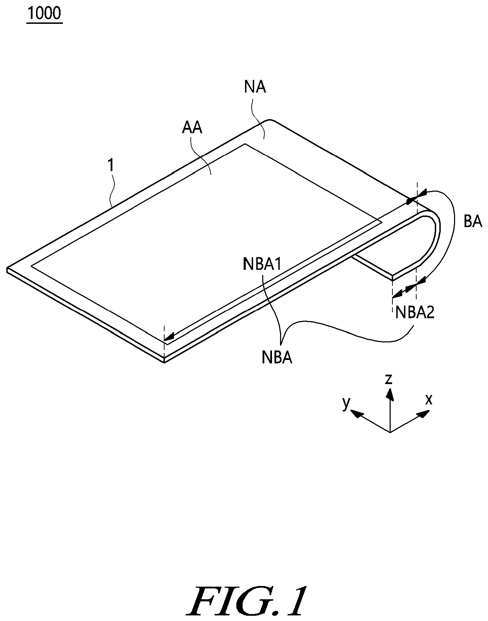

FIG. 1 is a view showing a display apparatus according to an embodiment of the present disclosure.

FIG. 1 is a view showing a state in which a display panel 1 of a display apparatus 1000 according to an embodiment of the present disclosure is in a bent state.

The display panel 1 may include a bending area BA and a non-bending area NBA. The non-bending area NBA may include at least two areas depending on the area of a substrate. For example, the substrate may have the bending area BA between two non-bending areas NBA.

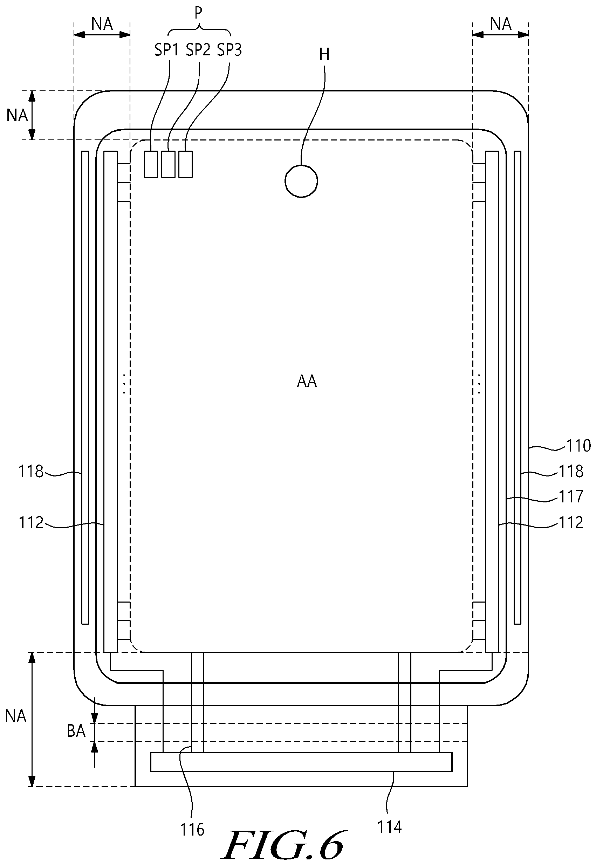

The bending area BA is an area where a portion of the display panel 1 is bendable or bent. Alternatively, the bending area BA is an area where a portion of a substrate 110 (for example, see FIG. 6) included in the display panel 1 is bent. For example, the bending area BA is an area where a portion of the substrate 110 is bent to dispose or move a pad part and an external module bonded to the pad part, on the rear surface of the substrate 110. For example, as the bending area BA is bent toward the rear surface of the substrate 110, the external module bonded to the pad part of the substrate 110 is moved toward the rear surface of the substrate 110, and may not be visible when viewing the substrate 110 from the top. In addition, as the bending area BA is bent, the size of a non-display area NA which is visible when viewing the substrate 110 from the top may decrease, so that a narrow bezel is implemented.

The non-bending area NBA is an area in which a portion of the substrate 110 is not bent or bendable and is flat. In the present disclosure, the non-bending area NBA may include two areas. For example, the non-bending area NBA may include a first non-bending area NBA1 where a plurality of subpixels are disposed to display an image, and a second non-bending area NBA2 where a pad part connected or bonded to a flexible film 2 is disposed.

The first non-bending area NBA1 and the second non-bending area NBA2 may face each other as the bending area BA is bent.

In other words, the first and second non-bending areas NBA1 and NBA2 may face each other in a state that the bending area BA is bent.

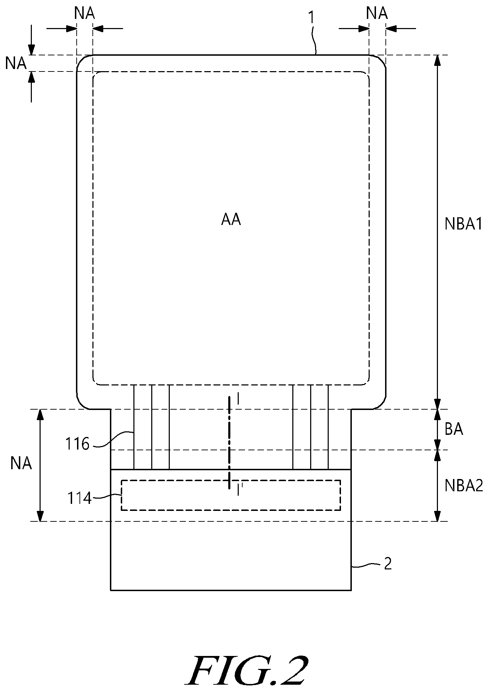

FIG. 2 is a plan view of a display panel according to an embodiment of the present disclosure.

Referring to FIG. 2, a display apparatus 1000 (for example, see FIG. 1) according to the embodiment of the present disclosure may include a display panel 1 and a flexible film 2.

As the display panel 1 being a panel which displays an image, all types of display panels, for example, such as a liquid crystal display panel, an organic light emitting diode (OLED) display panel and an electroluminescent display panel, may be used, and the embodiment of the present disclosure is not limited thereto.

The flexible film 2 may electrically connect the display panel 1 and a printed circuit board which generates a pixel driving signal and outputs the pixel driving signal to the display panel 1.

Alternatively, the flexible film 2 may transmit a signal outputted from a printed circuit board to the display panel 1 and/or transmit a signal from the printed circuit board to the printed circuit board.

The flexible film 2 may be made of a material with flexibility. For example, the flexible film 2 may be made of a plastic material such as polyimide (PI).

A first non-bending area NBA1 of a substrate 110 may include a display area (active area) AA and a non-display area (non-active area) NA which surrounds the display area AA. The non-display area NA of the substrate 110 may be adjacent to the display area AA, and may be disposed outside the display area AA.

The display area AA is an area where pixels P are disposed to display an image may include a plurality of subpixels (for example, first, second and third subpixels SP1, SP2 and SP3 as shown in FIG. 6, but not limited thereto), and in each of the plurality of subpixels, a light emitting element layer for displaying an image and a thin film transistor for driving the light emitting element layer may be disposed.

The non-display area NA is an area where an image is not displayed may be an area where various wirings and driving circuits for driving a plurality of subpixels disposed in the display area AA are disposed. Since the non-display area NA is not an area where an image is displayed, a partial area of the non-display area NA of the substrate 110 may be bent to reduce the non-display area NA, for example, a bezel area.

A pad part 114 may be disposed on one side of a second non-bending area NBA2 of the substrate 110. The pad part 114 may be a metal pattern to which an external module, for example, a flexible printed circuit board (FPCB) or a chip on film (COF), is bonded. Although the pad part 114 is shown as being disposed on one side of the substrate 110, the type and disposition of the pad part 114 are not limited thereto.

Connection wirings 116 may be disposed in a portion of the non-display area NA. The connection wirings 116 may be disposed in a bending area BA of the display apparatus and the first non-bending area NBA1 and the second non-bending area NBA2 adjacent to the bending area BA.

The connection wirings 116 may be components for transferring signals (e.g., voltages) from an external module bonded to the pad part 114 to the display area AA or a circuit unit such as a gate driver. For example, various signals and voltages, such as various gate signals, data signals, high potential voltages and low potential voltages, may be transferred through the connection wirings 116.

The connection wirings 116 may be divided into power connection wirings and/or signal connection wirings depending on voltages and/or image signals to be transferred.

The power connection wirings may transfer voltages supplied from the external module to the display area AA. The power connection wirings may be connected to a low-potential voltage wiring (VSS), a high-potential voltage wiring (VDD) and a gate low-voltage wiring and/or a gate high-voltage wiring included in the gate driver, but are not limited thereto.

The signal connection wirings may transfer signals supplied from the external module to the display area AA. The signal connection wirings may be connected to a scan line and/or a data line, but are not limited thereto.

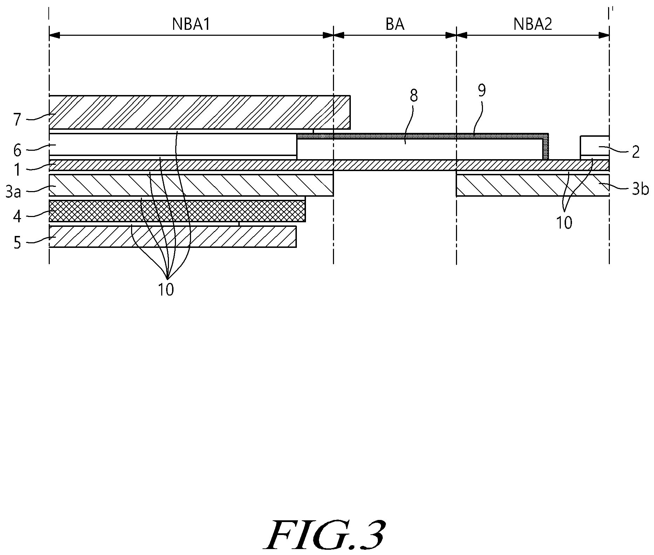

FIG. 3 is a view showing the display apparatus according to the embodiment of the present disclosure before bending. FIG. 3 is a cross-sectional view of the display apparatus corresponding to a line I-I' in the display panel of FIG. 2 according to an embodiment of the present disclosure.

Referring to FIG. 3, the display apparatus according to the embodiment of the present disclosure may include the display panel 1, a first protection member 8 and a second protection member 9.

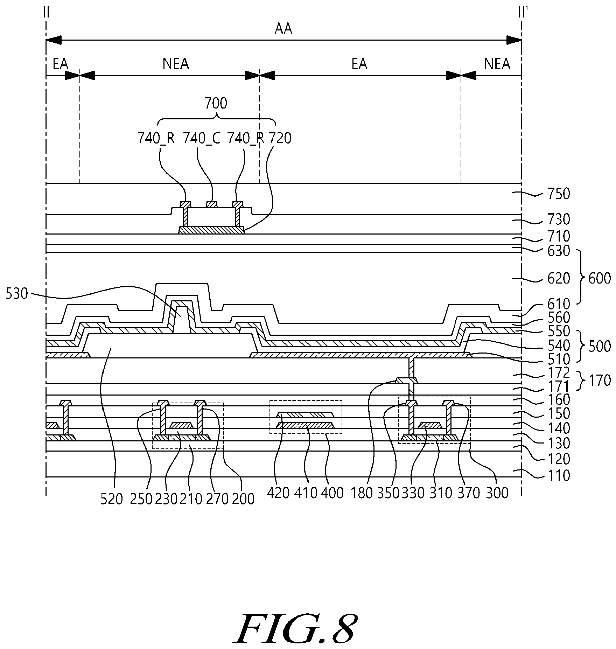

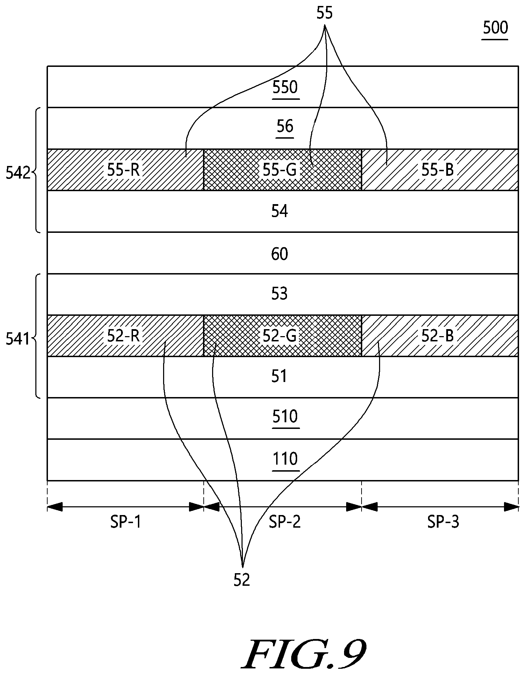

The display panel 1 may display an image or a picture in the display apparatus. The display panel 1 according to the embodiment of the present disclosure may include a light emitting diode display apparatus. The components of the display panel 1 will be described later with reference to FIGS. 8 and 9.

A polarizer 6, the first protection member 8, the second protection member 9 and a flexible film 2 may be disposed on the display panel 1.

The polarizer 6 may be disposed in the first non-bending area NBA1.

The polarizer 6 may selectively transmit light to reduce reflection of external light incident on the display apparatus 1000. For example, the display apparatus 1000 includes various metal materials to be applied to thin film transistors, light emitting element layers and wirings. External light incident on the display apparatus 1000 may be reflected from the metal materials, and visibility of the display apparatus 1000 may be reduced due to reflection of external light. Therefore, by disposing the polarizer 6 on one surface of the display apparatus 1000, reflection of external light may be prevented, and outdoor visibility of the display apparatus 1000 may be increased.

The polarizer 6 may be omitted depending on the structure of the display apparatus 1000, etc.

The polarizer 6 may be attached to the display panel 1 using an adhesive member 10.

The adhesive member 10 may be made of a material which has adhesive properties. For example, the adhesive member 10 may be made of optically clear adhesive (OCA), optically clear resin (OCR) or pressure sensitive adhesive (PSA), but is not limited thereto.

The first protection member 8 may be disposed in the bending area BA. Alternatively, the first protection member 8 may also be disposed in the first non-bending area NBA1 and/or the second non-bending area NBA2 adjacent to the bending area BA.

The first protection member 8 may prevent or at least reduce problems such as cracking and penetration of external moisture occurring when the display panel 1 is bent. Alternatively, the first protection member 8 may prevent or at least reduce problems such as cut-off of the connection wirings 116 or penetration of external moisture and/or oxygen into the display panel 1 due to external impacts applied to the bending area BA after bending.

The first protection member 8 may be disposed to cover at least a portion of the display panel 1 which is disposed in the bending area BA.

The first protection member 8 may include resin. Ultraviolet (UV)-curable acrylic resin or epoxy resin may be used, but the embodiment of the present disclosure is not limited thereto.

The first protection member 8 may be formed of a cured material of resin that has undergone a curing process after being coated. If UV-curable resin is used as the resin, curing may be performed through UV curing.

The second protection member 9 may be disposed on the first protection member 8.

The second protection member 9 may be disposed in the bending area BA. Alternatively, the second protection member 9 may be disposed in the first non-bending area NBA1 and/or the second non-bending area NBA2 adjacent to the bending area BA.

The second protection member 9 may prevent or at least reduce a problem that the physical properties of the first protection member 8 change due to the curing process for a third protection member 11.

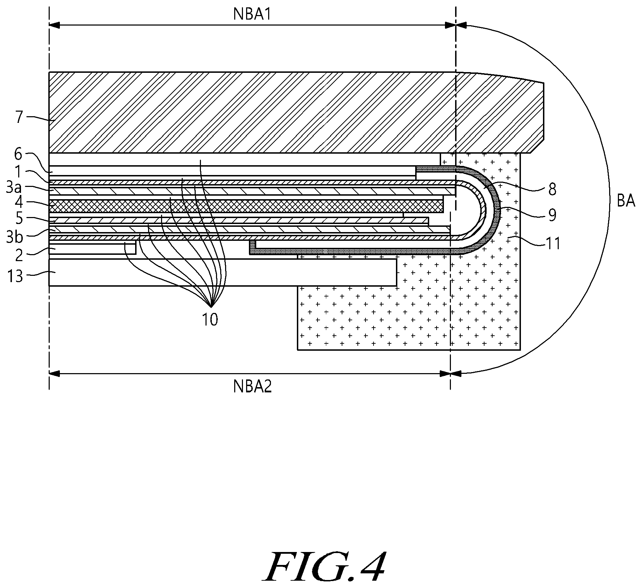

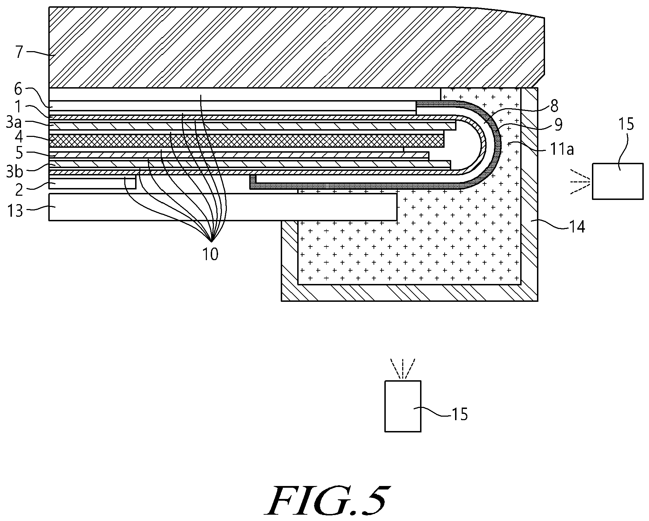

Referring to FIG. 4 and FIG. 5 together, the first protection member 8, the second protection member 9, and the third protection member 11 may be disposed in that order from the inside to the outside of the display apparatus.

The third protection member 11 may be formed using resin having a high tensile modulus. During a process of forming the third protection member 11, light may be irradiated to cure a material 11a of the third protection member 11. For example, as the material 11a of the third protection member 11 is cured using ultraviolet rays, the third protection member 11 may be formed.

During the manufacturing process of the third protection member 11, ultraviolet rays may penetrate not only the third protection member 11 but also the first protection member 8, so that the physical properties of the first protection member 8 change. This may cause over-curing of the first protection member 8, causing cracking or cut-off of the display panel 1. Therefore, by disposing the second protection member 9 between the first protection member 8 and the third protection member 11, change in the physical properties of the first protection member 8 likely to occur due to the processing process of the third protection member 11 during a processing process in which the first protection member 8 is cured may be minimized. In addition, since a plurality of protection members are disposed, breakage of the display apparatus due to external impacts may be minimized, and since cracking and delamination of the display panel are prevented, a signal may be normally transferred, whereby it is possible to provide a display apparatus with improved reliability and capable of low power consumption.

The second protection member 9 may be disposed to cover at least a portion of the first protection member 8. The second protection member 9 may cover one end of the first protection member 8. One end of the second protection member 9 may at least partially contact the display panel 1.

The other end of the second protection member 9 may at least partially contact the polarizer 6 or an adhesive member 10 which attaches (or bonds) the polarizer 6 and a front surface member 7.

The upper surface of the second protection member 9 may at least partially contact the front surface member 7.

The second protection member 9 may include a black material. The second protection member 9 may be an adhesive member which has adhesive properties. For example, the second protection member 9 may be made of pressure sensitive adhesive (PSA) which includes a black material and simultaneously has adhesive properties, but is not limited thereto. The second protection member 9 may be arranged and/or configured to block ultraviolet light from being irradiated to the first protection member 8.The second protection member 9 may block ultraviolet light from being irradiated to the first protection member 8.

The second protection member 9 may include an ultraviolet blocking material, and the third protection member 11 may include an ultraviolet transmitting material.

The flexible film 2 may be disposed in the second non-bending area NBA2.

The flexible film 2 may be attached to the display panel 1 using an adhesive member 10. The adhesive member 10 may be made of a material which has adhesive properties. For example, the adhesive member 10 may be made of optically clear adhesive (OCA) or pressure sensitive adhesive (PSA), but is not limited thereto.

The front surface member 7 may be disposed on the polarizer 6, the first protection member 8 and the second protection member 9. The front surface member 7 may be disposed in the first non-bending area NBA1 and the bending area BA. The front surface member 7 may be disposed on or form a front surface and/or front side of the display panel 1 and/or the display apparatus.

The front surface member 7 may protect the display panel 1 and other components located below or over the front surface member 7 from external impact, moisture, heat, etc. The front surface member 7 may be made of a material which has impact resistance and light transparency. For example, the front surface member 7 may be a substrate made of glass or a film made of a plastic material such as polymethylmethacrylate (PMMA), polyimide (PI) and polyethylene terephthalate (PET), but is not limited thereto. The front surface member 7 may be referred to as various names such as a cover window, a window cover or a cover glass, and embodiments of the present disclosure are not limited thereto.

The front surface member 7 may be formed to be transparent so that light emitted from the display panel 1 may be transmitted to the outside of the display apparatus and a user may view an image provided by the display apparatus.

A blocking part may be disposed at the end of the front surface member 7. The blocking part may be disposed to surround a portion of the end of the display panel 1. The blocking part may be formed to be opaque so that wirings, driving circuits and various components formed below or over the front surface member 7 in the display apparatus are not visible to the user.

The blocking part may include a light blocking material such as pigment, dye and carbon black. For example, the blocking part may be formed or coated on the front surface member 7 with black ink. Alternatively, the blocking part may be formed as a separate part on the edge of the rear surface of the front surface member 7, and may be attached to the front surface member 7.

The blocking part may be disposed to overlap a portion of at least one of the display panel 1, a first plate 3a, a support member 4 and a heat dissipation member 5. When the display panel 1 is bent, the blocking part may be disposed to overlap a portion of at least one of a second plate 3b and the flexible film 2.

A plate may be disposed on the rear surface of the display panel 1. The plate may support and protect the display panel 1 on the rear surface of the display panel 1. The plate may be made of a material which is rigid and has high thermal conductivity. For example, the plate may be made of a metal such as aluminum (Al), copper (Cu), zinc (Zn), silver (Ag), gold (Au), iron (Fe), SUS (stainless steel) and Invar or a material such as plastic, and the embodiments of the present disclosure are not limited thereto.

In the present disclosure, the plate may include the first plate 3a and the second plate 3b. The first plate 3a may be disposed in the first non-bending area NBA1, and may support the display panel 1 which has flexible features, in correspondence to the display area AA of the display panel 1, so that the display panel 1 may maintain a flat state. The second plate 3b may be disposed in the second non-bending area NBA2, and may support the display panel 1 which has flexible features and the flexible film 2.

The first plate 3a and the second plate 3b may be attached to the display panel 1 using adhesive members 10.

The adhesive members 10 may be made of a material which has adhesive properties. For example, the adhesive members 10 may be made of optically clear adhesive (OCA) or pressure sensitive adhesive (PSA), but are not limited thereto.

A support member 4 may be disposed on the rear surface of the first plate 3a in the first non-bending area NBA1.

The support member 4 may support at least one of the rear surface and the side surface of the display panel 1, and may have a plate shape.

The support member 4 may be made of a material which has high rigidity and high thermal conductivity. For example, the support member 4 may be made of a metal such as aluminum (Al), copper (Cu), zinc (Zn), silver (Ag), gold (Au), iron (Fe), SUS (stainless steel) and Invar or a material such as plastic, and the embodiments of the present disclosure are not limited thereto.

The support member 4 may be attached to the first plate 3a using an adhesive member 10.

The adhesive member 10 may be made of a material which has adhesive properties. For example, the adhesive member 10 may be made of optically clear adhesive (OCA) or pressure sensitive adhesive (PSA), but is not limited thereto.

A heat dissipation member 5 may be disposed on the rear surface of the support member 4. The heat dissipation member 5 may be at least partially disposed between the support member 4 and the second plate 3b when the display panel 1 is bent.

The heat dissipation member 5 may dissipate heat transferred from the display panel 1. The heat dissipation member 5 may include a material with excellent thermal conductivity. The heat dissipation member 5 may disperse and dissipate heat transferred from the display panel 1. For example, the heat dissipation member 5 may be made of a metal such as aluminum (Al), copper (Cu), zinc (Zn), silver (Ag), gold (Au), iron (Fe), SUS (stainless steel), Invar and graphite or a material such as plastic and may include at least one of materials as mentioned above, an alloy thereof or a joint structure thereof, and the embodiments of the present disclosure are not limited thereto.

FIG. 4 is a cross-sectional view of a display apparatus according to an embodiment of the present disclosure.

Referring to FIG. 4, the display apparatus according to the embodiment of the present disclosure may include a first protection member 8, a second protection member 9 and a third protection member 11. Since FIG. 4 is substantially the same as FIG. 3 except that FIG. 4 shows a configuration after bending, repeated description will be omitted.

In FIG. 4, after attaching the display panel and the components disposed on the rear surface and the front surface of the display panel, a bending process may be performed. After the bending process, the first non-bending area NBA1 and the second non-bending area NBA2 may face each other. By the bending process, the second plate 3b and the heat dissipation member 5 may be attached using an adhesive member 10.

The bent display apparatus may further include a frame 13. The frame 13 is a component which protects the display panel 1 from external impacts and mounts the display panel 1 and the components of the display panel 1, and may be disposed under the flexible film 2 and the second protection member 9.

Hereinafter, the first protection member 8, the second protection member 9 and the third protection member 11 will be described in detail.

The first protection member 8 disposed in the bending area BA may be disposed on the display panel 1, the second protection member 9 may be disposed on the first protection member 8, and the third protection member 11 may be disposed on the second protection member 9.

The first protection member 8 and the second protection member 9 may be disposed along the bending area BA. For example, the first protection member 8 and the second protection member 9 may be formed on the display panel 1 in the bending area BA before the bending process, and may be bent together with the display panel 1 during the bending process to be disposed along the bending area BA.

The third protection member 11 may cover the side surface of the bending area BA. The frame 13 which is formed to reinforce the side surface of the display panel 1 after the bending process may be disposed to cover the back side and/or side surface of the display apparatus. The third protection member 11 may further cover the lower surface of the bending area BA.

The second protection member 9 and the third protection member 11 may be made of different materials.

The second protection member 9 may be made of pressure sensitive adhesive (PSA) which includes a black material and simultaneously has adhesive properties, but is not limited thereto. The second protection member 9 may include a UV blocking material. Therefore, the second protection member 9 may block ultraviolet light from being irradiated to the first protection member 8.

The third protection member 11 may include resin, but is not limited thereto. The third protection member 11 may include a material which transmits ultraviolet. Accordingly, the third protection member 11 may be cured as ultraviolet is irradiated to a material 11a of the third protection member 11.

The tensile modulus of the first protection member 8 may be different from the tensile modulus of the third protection member 11. The tensile modulus of the third protection member 11 may be equal to or smaller than the tensile modulus of the first protection member 8.

The connection wirings 116 disposed in the bending area BA may be vulnerable to impacts, and may be cut off to cause a problem that the display apparatus is not driven. Although the first protection member 8 is disposed in the bending area BA, in order to more effectively alleviate the impacts applied to the side surface of the display apparatus, a third protection member 11 which has a tensile modulus greater than that of the first protection member 8 may be disposed.

The third protection member 11 which has a high tensile modulus protects the connection wirings 116 disposed in the bending area BA to have an effect of preventing or at least reducing the connection wirings 116 from being cut off due to external impacts. In addition, the third protection member 11 has an effect of preventing the display panel 1 from being broken or damaged, for example, being crushed or deformed.

FIG. 5 is a view showing a manufacturing process of the third protection member according to the embodiment of the present disclosure.

A curing container 14 may be disposed at a location where the bending area BA of the display apparatus 1000 is disposed. The curing container 14 has a structure which is closed except an upper surface, and the bending area BA of the display apparatus 1000 may be disposed in the curing container 14.

Thereafter, the material 11a of the third protection member 11 is placed in the curing container 14. Since the material 11a of the third protection member 11 is made of resin with high viscosity and low fluidity, it takes a time for the material 11a to flow.

By irradiating light to the material 11a of the third protection member 11 using curing equipment 15 on the side surface and the lower surface of the curing container 14, the third protection member 11 may be cured.

The light of the curing equipment 15 may be ultraviolet.

FIG. 6 is a plan view showing components disposed in a display panel according to an embodiment of the present disclosure.

Referring to FIG. 6, a substrate 110 may include a display area (active area) AA and a non-display area (non-active area) NA which surrounds the display area AA. The non-display area NA of the substrate 110 may be adjacent to the display area AA, and may be disposed outside the display area AA.

The display area AA is an area where pixels P are disposed and an image is displayed.

Each pixel P which is disposed in the display area AA may include a plurality of subpixels (for example, first, second and third subpixels SP1, SP2 and SP3, but not limited thereto). The plurality of subpixels are individual units that emit light. The plurality of subpixels may emit red, green, blue and/or white, and the embodiments of the present disclosure are not limited thereto.

The display area AA may include an organic light emitting diode. Alternatively, the display area AA may include a light emitting diode (LED) or a micro light emitting diode (micro-LED) including an inorganic material, but the embodiments of the present disclosure are not limited thereto.

In each of the plurality of subpixels, a light emitting element layer for displaying an image and a thin film transistor for driving the light emitting element layer may be disposed.

One subpixel may include a plurality of transistors T, a capacitor C and a plurality of wirings. For example, one subpixel may be a structure 2T1C including two transistors and one capacitor, but is not limited thereto. One subpixel may be a structure such as 3T1C, 4T1C, 5T1C, 6T1C, 7T1C, 3T2C, 4T2C, 5T2C, 6T2C, 7T2C and 8T2C, and may be implemented depending on the structure and type of thin film transistors.

The non-display area NA as an area where an image is not displayed is an area where various wirings and driving circuits for driving the plurality of subpixels disposed in the display area AA are disposed. Since the non-display area NA is not an area where an image is displayed, a partial area of the non-display area NA of the substrate 110 may be bent to reduce the non-display area NA, for example, a bezel area.

As shown in FIG. 6, the non-display area NA may be disposed around the display area AA. For example, the non-display area NA may be an area which surrounds the display area AA. The non-display area NA may be an area which extends from the display area AA. Alternatively, the non-display area NA may be an area where the plurality of subpixels are not disposed, but is not limited thereto.

FIG. 6 shows that the non-display area NA surrounds the display area AA of a quadrangular shape. However, the shape of the display area AA and the shape and disposition of the non-display area NA adjacent to the display area AA are not limited to the example shown in FIG. 6. The display area AA and the non-display area NA may have a shape suitable for the design of an electronic device which is equipped with the display apparatus 1000. In the case of the display apparatus of a device which is wearable by a user, the display apparatus may have a circular shape such as a wristwatch, and the concepts of embodiments of the present disclosure may also be applied even to a free-form display apparatus which may be applied to the dashboard of a vehicle, etc. For example, the display area AA may have a pentagonal, hexagonal, circular or oval shape, but is not limited thereto.

The non-display area NA is an area where various wirings and driving circuits for driving the plurality of subpixels disposed in the display area AA are disposed. For example, various ICs and driving circuits such as a gate driver and a data driver may be disposed in the non-display area NA. The non-display area NA may be a bezel area, and is not limited to the term.

The display apparatus 1000 according to the embodiment of the present disclosure may include various additional elements for generating various signals or driving the plurality of subpixels in the display area AA. For example, driving circuits for controlling (or driving) the plurality of subpixels may include a gate driver 112, data signal lines, a multiplexer (MUX), an electrostatic discharge (ESD) circuit, a power wiring, an inverter circuit, and connection wirings 116. The power wiring may be a high-potential voltage wiring and/or a low-potential voltage wiring, but the embodiments of the present disclosure are not limited thereto. The display apparatus 1000 may also include additional elements having functions other than functions for driving the plurality of subpixels. For example, the display apparatus 1000 may include additional elements which provide a touch detection function, a user authentication function (e.g., fingerprint recognition), a multi-level pressure detection function and a tactile feedback function, and the embodiments of the present disclosure are not limited thereto. The additional elements mentioned above may be located in the non-display area NA or an external circuit connected to a connection interface, and the embodiments of the present disclosure are not limited thereto.

A pad part 114 may be disposed on one side of the non-display area NA. The pad part 114 may be a metal pattern to which an external module, for example, a flexible printed circuit board (FPCB) or a chip on film (COF), is bonded. Although the pad part 114 is shown as being disposed on one side of the substrate 110, the type and disposition of the pad part 114 are not limited thereto.

The gate driver 112 which provides a gate signal to a thin film transistor may be disposed on one side and the other side of the non-display area NA. The gate driver 112 may include various gate driving circuits, and the gate driving circuits may be formed directly on the substrate 110. In this case, the gate driver 112 may be a gate-in-panel (GIP), and is not limited to the term.

The gate driver 112 may be disposed between the display area AA and a dam 117. Between the display area AA and the pad part 114 of the non-display area NA, a high-potential voltage wiring (VDD), a low-potential voltage wiring (VSS), a multiplexer (MUX), an electrostatic discharge (ESD) circuit and the connection wirings 116 may be disposed, but the embodiments of the present disclosure are not limited thereto.

The high-potential voltage wiring (VDD), the low-potential voltage wiring (VSS), the multiplexer (MUX) and the connection wirings 116 may be disposed between the display area AA and a bending area BA. The high-potential voltage wiring (VDD), the low-potential voltage wiring (VSS), the multiplexer (MUX) and the connection wirings 116 may be disposed in a non-bending area adjacent to the display area AA.

The connection wirings 116 may be disposed in a portion of the non-display area NA. The connection wirings 116 may be disposed in the bending area BA of the display apparatus and the non-bending area adjacent to the bending area BA.

The connection wiring 116 may be a component for transferring a signal (e.g., a voltage) from an external module bonded to the pad part 114 to the display area AA or a circuit unit such as the gate driver 112. For example, various signals and voltages, such as various gate signals, data signals, high potential voltages and low potential voltages, may be transferred through the connection wirings 116.

The connection wirings 116 may be divided into power connection wirings and/or signal connection wirings depending on voltages and/or image signals to be transferred.

The power connection wirings may transfer voltages supplied from the external module to the display area AA. The power connection wirings may be connected to the low-potential voltage wiring (VSS), the high-potential voltage wiring (VDD) and a gate low-voltage wiring and/or a gate high-voltage wiring included in the gate driver, but are not limited thereto.

The signal connection wirings may transfer signals supplied from the external module to the display area AA. The signal connection wirings may be connected to scan lines and/or data lines, but are not limited thereto.

The dam 117 may be disposed in the non-display area NA to surround the entirety or a part of the display area AA. The dam 117 may be adjacent to the display area AA, and may be disposed outside the display area AA.

The dam 117 may be disposed along the periphery of the display area AA to control the flow of a layer including an organic material in an encapsulation part disposed on the light emitting element layer. The number of dams 117 may be one or multiple, and the embodiments of the present disclosure are not limited thereto.

A panel crack detector 118 may be further disposed in a portion of the non-display area NA of the substrate 110.

The panel crack detector 118 may be disposed between the end point (or end) of the substrate 110 and the dam 117. Alternatively, the panel crack detector 118 may be disposed below the dam 117, and may at least partially overlap the dam 117.

The panel crack detector 118 may be disposed at the outer part of the display apparatus, and may detect a defect such as a crack that may occur on the outer part of the display apparatus.

A hole H may be further included inside the display area AA. The hole H may be disposed between the plurality of subpixels in the display area AA. The hole H may be an area where an optical part such as a camera or an optical sensor is disposed. The optical sensor may include a proximity sensor, an infrared sensor, an ultraviolet sensor, etc., but the embodiments of the present disclosure are not limited thereto. Since the hole H includes a hole H which penetrates a certain component of the display apparatus 1000 to dispose the optical part, it is possible to secure a space in which the optical part is to be disposed.

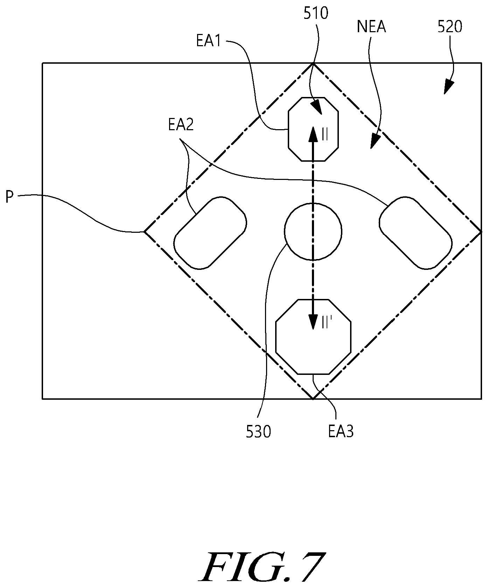

FIG. 7 is a plan view showing the pixel disposition of a display apparatus according to an embodiment of the present disclosure.

The display area AA of the substrate 110 may include light emitting parts EA (for example, see FIG. 8) and a non-light emitting part NEA which is disposed between the light emitting parts EA.

The light emitting part EA is an area where light is emitted from a light emitting element layer in the subpixel, and each subpixel may include a light emitting part EA. A plurality of light emitting parts EA may be disposed on the substrate to be spaced apart from each other. The non-light emitting part NEA may be disposed to surround the light emitting part EA.

The light emitting part EA is an area where light is emitted to the outside from a light emitting layer. Referring to FIG. 8, the light emitting part EA may be an area where a bank 520 is not disposed.

The non-light emitting area NEA is an area where light is not emitted to the outside from a light emitting layer. Referring to FIG. 8, the non-light emitting area NEA may be an area where the bank 520 is disposed.

A plurality of light emitting parts which emit different colors may be located in the light emitting parts EA. For example, a first light emitting part EA1 which emits red light, a second light emitting part EA2 which emits green light and a third light emitting part EA3 which emits blue light may be included. The first to third light emitting parts may form a pixel P. In addition, a light emitting part which emits white light, etc. may be included, but the embodiments of the present disclosure are not limited thereto. The first light emitting part EA1 may be included in the first subpixel SP1, the second light emitting part EA2 may be included in the second light emitting part SP2, and the third light emitting part EA3 may be included in the third light emitting part SP3.

The respective light emitting parts EA are formed in specific shapes and are arranged in a specific pattern as shown in FIG. 7, but the light emitting parts EA of the display apparatus 1000 according to the embodiment of the present disclosure may not be formed and arranged in only the specific shapes and pattern but may be formed and arranged in various shapes and patterns. For example, each of the light emitting parts EA may have a quadrangular, pentagonal, hexagonal, octagonal, circular or oval shape, but is not limited thereto. For example, the first light emitting part EA1 and the third light emitting part EA3 may have the same shape. The second light emitting part EA2 may have a different shape from the first light emitting part EA1. The second light emitting part EA2 may have a different shape from the third light emitting part EA3. For example, the second light emitting part EA2 may have a different shape from the first light emitting part EA1 and the third light emitting part EA3.

As shown in FIG. 6, in one pixel P, a plurality of subpixels or light emitting parts may emit the same color. For example, at least two second subpixels SP2 or second light emitting parts EA2 may be disposed in one pixel P. At least two second light emitting parts EA2 which emit green may be disposed in one pixel P, but the embodiments of the present disclosure are not limited thereto.

The third light emitting part EA3 may have a larger area than other light emitting parts. For example, the area of the third light emitting part EA3 may be larger than the area of the first light emitting part EA1. The area of the third light emitting part EA3 which emits blue may be larger than the area of the first light emitting part EA1 which emits red. For example, the area of the third light emitting part EA3 may be larger than the area of the second light emitting part EA2. The area of the third light emitting part EA3 which emits blue may be larger than the area of the second light emitting part EA2 which emits green. The third light emitting part EA3 may be disposed over other light emitting parts. For example, the third light emitting part EA3 may overlap at least portions of the first light emitting part EA1 and the second light emitting part EA2.

A spacer 530 may be disposed to have a preset distance (or separation distance) from the plurality of subpixels. For example, the spacer 530 may be disposed to be spaced apart from the plurality of subpixels at a set distance and be surrounded by the plurality of subpixels. For example, as shown in FIG. 7, four subpixels may surround one spacer, but the embodiments of the present disclosure are not limited thereto. Depending on the structure and type of the display apparatus, five, six, seven or eight subpixels may be implemented to surround one spacer.

The spacer 530 may be disposed substantially at the center between a plurality of subpixels which emit at least one same color. For example, the spacer 530 may be disposed at the center between two second light emitting parts EA2 which emit green.

The spacer 530 may buffer the empty space between the substrate 110 on which a light emitting element layer 500 (for example, see FIG. 8) is formed and an upper substrate to minimize breakage of the display apparatus 1000 due to external impacts.

In addition, the spacer 530 may protect the light emitting element layer 500. For example, when forming the light emitting element layer 500, a fine metal mask (FMM) may be used. The fine metal mask may sag during a processing process thereof due to the weight thereof. Therefore, by disposing the spacer 530 to bring the fine metal mask (FMM) and the spacer 530 into contact with each other, the fine metal mask may be prevented from being brought into direct contact with the bank 520 to deform or damage the bank 520.

FIG. 8 is a cross-sectional view of a display panel according to an embodiment of the present disclosure. The display panel shown in Fig. 8 may be a display panel 1 as described in reference to the previous figures.

FIG. 8 is a view showing a portion of the cross-sectional structure of a subpixel which is disposed in a display area where an image is displayed. In the subpixel, a light emitting element layer 500 for displaying an image and a first thin film transistor 200 and a second thin film transistor 300 for driving the light emitting element layer 500 may be disposed.

The substrate 110 may support various components of a display apparatus. The substrate 110 may be made of glass or a plastic material with flexibility.

For example, the substrate 110 may be formed of at least one among polyimide (PI), polymethylmethacrylate (PMMA), polyethylene terephthalate (PET), polyethersulfone and polycarbonate (PC), but is not limited thereto.

When the substrate 110 is made of polyimide, the substrate 110 may be configured with two polyimide layers. An inorganic layer may be further disposed between the two polyimide layers, but embodiments of the present disclosure are not limited thereto.

The substrate 110 may be referred to as a concept including elements and functional layers formed on the substrate 110, for example, a switching thin film transistor, a driving thin film transistor connected to the switching thin film transistor, an organic light emitting element connected to the driving thin film transistor, a protective layer, and so on, but is not limited thereto.

A first insulating layer 120 may be disposed over the entirety of the substrate 110. For example, the first insulating layer 120 may be disposed on the entire surface of the substrate 110.

The first insulating layer 120 may be formed on the substrate 110 to block a material inside the substrate 110 from moving to a thin film transistor or a semiconductor layer during a deposition process.

The first insulating layer 120 may be formed of an insulating inorganic material such as silicon nitride (SiNx) or silicon oxide (SiOx) and besides, may be formed of an insulating organic material, but is not limited thereto.

The first insulating layer 120 may be made of a single layer or a multilayer of silicon nitride (SiNx) and/or silicon oxide (SiOx), but the embodiments of the present disclosure are not limited thereto. When the first insulating layer 120 is made of a multilayer, silicon oxide (SiOx) and silicon nitride (SiNx) may be alternately formed, but the embodiments of the present disclosure are not limited thereto.

The first insulating layer 120 may be a buffer layer or a first buffer layer, but the embodiments of the present disclosure are not limited thereto.

The first insulating layer 120 may be omitted depending on the type and material of the substrate 110, the structure and type of a thin film transistor, and so on.

The first thin film transistor 200 and the second thin film transistor 300 may be disposed on the first insulating layer 120. The first thin film transistor 200 may be a switching thin film transistor and the second thin film transistor 300 may be a driving thin film transistor, but the embodiments of the present disclosure are not limited thereto.

The first thin film transistor 200 may include a first semiconductor layer 210, a first gate electrode 230, a first source electrode 250, and a first drain electrode 270. The second thin film transistor 300 may include a second semiconductor layer 310, a second gate electrode 330, a second source electrode 350, and a second drain electrode 370.

For the sake of convenience in explanation, only two thin film transistors among various thin film transistors are shown, but other thin film transistors may also be included in the display apparatus 1000. In addition, for the sake of convenience in explanation, a top gate structure in which a gate electrode configuring a thin film transistor is located over a semiconductor layer has been described, but the embodiments of the present disclosure are not limited to this structure. A bottom gate structure in which a gate electrode is located below a semiconductor layer or a double gate structure in which gate electrodes are located at both over and below a semiconductor layer may be implemented.

The first semiconductor layer 210 of the first thin film transistor 200 and the second semiconductor layer 310 of the second thin film transistor 300 may be disposed on the first insulating layer 120.

The first semiconductor layer 210 and the second semiconductor layer 310 may be made of a polycrystalline semiconductor. For example, the polycrystalline semiconductor may include low temperature poly silicon (LTPS) having high mobility, but is not limited thereto. When the first semiconductor layer 210 and the second semiconductor layer 310 are made of a polycrystalline semiconductor, energy consumption power is low and reliability is excellent.

The first semiconductor layer 210 and the second semiconductor layer 310 may be made of an oxide semiconductor. For example, the first semiconductor layer 210 and the second semiconductor layer 310 may be made of any one of IGZO (indium-gallium-zinc-oxide), IZO (indium-zinc-oxide), IGTO (indium-gallium-tin-oxide) and IGO (indium-gallium-oxide), but are not limited thereto. When the first semiconductor layer 210 and the second semiconductor layer 310 are made of an oxide semiconductor, the effect of blocking leakage current is excellent, and thus, it is possible to minimize a change in the luminance of a subpixel during low-speed driving.

When the first semiconductor layer 210 and the second semiconductor layer 310 are made of a polycrystalline semiconductor or an oxide semiconductor, partial areas of the first semiconductor layer 210 and the second semiconductor layer 310 may have conductive areas.

The first semiconductor layer 210 and the second semiconductor layer 310 may be made of amorphous silicon (a-Si) or may be made of various organic semiconductor materials such as pentacene, but are not limited thereto.

A second insulating layer 130 may be disposed over the entire area of the substrate 110 on the first semiconductor layer 210 and the second semiconductor layer 310.

The second insulating layer 130 may be disposed between the first semiconductor layer 210 and the first gate electrode 230 to insulate the first semiconductor layer 210 and the first gate electrode 230. The second insulating layer 130 may be disposed between the second semiconductor layer 310 and the second gate electrode 330 to insulate the second semiconductor layer 310 and the second gate electrode 330.

The second insulating layer 130 may be formed of an insulating inorganic material such as silicon nitride (SiNx) or silicon oxide (SiOx) and besides, may be formed of an insulating organic material, but the embodiments of the present disclosure are not limited thereto.

The second insulating layer 130 may have a hole to electrically connect each of the first source electrode 250 and the first drain electrode 270 to the first semiconductor layer 210. The second insulating layer 130 may have a hole to electrically connect each of the second source electrode 350 and the second drain electrode 370 to the second semiconductor layer 310.

The first gate electrode 230 of the first thin film transistor 200 and the second gate electrode 330 of the second thin film transistor 300 may be disposed on the second insulating layer 130. The first gate electrode 230 may be disposed to overlap the first semiconductor layer 210. The second gate electrode 330 may be disposed to overlap the second semiconductor layer 310.

A storage capacitor 400 may be disposed on the second insulating layer 130. The storage capacitor 400 may include a first capacitor electrode 410 and a second capacitor electrode 420. The storage capacitor 400 may store a data voltage applied through a data line, for a predetermined period, and then, may provide the data voltage to a first electrode 510.

The first capacitor electrode 410 of the storage capacitor 400 may be disposed on the second insulating layer 130.

The first gate electrode 230, the second gate electrode 330 and the first capacitor electrode 410 may be disposed at the same layer. For example, the first gate electrode 230, the second gate electrode 330 and the first capacitor electrode 410 may be disposed on the second insulating layer 130.

The first gate electrode 230, the second gate electrode 330 and the first capacitor electrode 410 may be formed through the same process.

The first gate electrode 230, the second gate electrode 330 and the first capacitor electrode 410 may be formed as a single layer or a multilayer made of any one or an alloy of molybdenum (Mo), copper (Cu), titanium (Ti), aluminum (Al), chromium (Cr), gold (Au), nickel (Ni), neodymium (Nd), tungsten (W) and transparent conductive oxide (TCO), but the embodiments of the present disclosure are not limited thereto.

A third insulating layer 140 may be disposed over the entire area of the substrate 110 on the first gate electrode 230, the second gate electrode 330 and the first capacitor electrode 410.

The third insulating layer 140 may be disposed between the first gate electrode 230, the first source electrode 250 and the first drain electrode 270 to insulate the first gate electrode 230, the first source electrode 250 and the first drain electrode 270. The third insulating layer 140 may be disposed between the second gate electrode 330, the second source electrode 350 and the second drain electrode 370 to insulate the second gate electrode 330, the second source electrode 350 and the second drain electrode 370.

The third insulating layer 140 may have a hole to electrically connect each of the first source electrode 250 and the first drain electrode 270 to the first semiconductor layer 210. The third insulating layer 140 may have a hole to electrically connect each of the second source electrode 350 and the second drain electrode 370 to the second semiconductor layer 310.

The third insulating layer 140 may be formed of an insulating inorganic material such as silicon nitride (SiNx) or silicon oxide (SiOx) and besides, may be formed of an insulating organic material, but the embodiments of the present disclosure are not limited thereto.

The second capacitor electrode 420 of the storage capacitor 400 may be disposed on the third insulating layer 140. The second capacitor electrode 420 may be disposed to overlap the first capacitor electrode 410.

The second capacitor electrode 420 may be formed as a single layer or a multilayer made of any one or an alloy of molybdenum (Mo), copper (Cu), titanium (Ti), aluminum (Al), chromium (Cr), gold (Au), nickel (Ni), neodymium (Nd), tungsten (W) and transparent conductive oxide (TCO), but the embodiments of the present disclosure are not limited thereto.

A fourth insulating layer 150 may be disposed over the entire area of the substrate 110 on the second capacitor electrode 420.

The fourth insulating layer 150 may be disposed between the first gate electrode 230, the first source electrode 250 and the first drain electrode 270 to insulate the first gate electrode 230, the first source electrode 250 and the first drain electrode 270. The fourth insulating layer 150 may be disposed between the second gate electrode 330, the second source electrode 350 and the second drain electrode 370 to insulate the second gate electrode 330, the second source electrode 350 and the second drain electrode 370.

The fourth insulating layer 150 may have a hole to electrically connect each of the first source electrode 250 and the first drain electrode 270 to the first semiconductor layer 210. The fourth insulating layer 150 may have a hole to electrically connect each of the second source electrode 350 and the second drain electrode 370 to the second semiconductor layer 310.

The fourth insulating layer 150 may be formed of an insulating inorganic material such as silicon nitride (SiNx) or silicon oxide (SiOx) and besides, may be formed of an insulating organic material, but the embodiments of the present disclosure are not limited thereto.

The first source electrode 250 and the first drain electrode 270 may be disposed on the fourth insulating layer 150. The second source electrode 350 and the second drain electrode 370 may be disposed on the fourth insulating layer 150.

Each of the first source electrode 250 and the first drain electrode 270 may be electrically connected to the first semiconductor layer 210 through the holes of the second insulating layer 130, the third insulating layer 140 and the fourth insulating layer 150. Each of the second source electrode 350 and the second drain electrode 370 may be electrically connected to the second semiconductor layer 310 through the holes of the second insulating layer 130, the third insulating layer 140 and the fourth insulating layer 150.

The first source electrode 250, the first drain electrode 270, the second source electrode 350 and the second drain electrode 370 may be formed as a single layer or a multilayer made of any one or an alloy of molybdenum (Mo), copper (Cu), titanium (Ti), aluminum (Al), chromium (Cr), gold (Au), nickel (Ni), neodymium (Nd), tungsten (W) and transparent conductive oxide (TCO), but the embodiments of the present disclosure are not limited thereto. For example, the first source electrode 250, the first drain electrode 270, the second source electrode 350 and the second drain electrode 370 may be made of a three-layered structure of titanium (Ti)/aluminum (Al)/titanium (Ti) as conductive metal materials, but the embodiments of the present disclosure are not limited thereto.

A fifth insulating layer 160 may be disposed over the entire area of the substrate 110 on the first source electrode 250, the first drain electrode 270, the second source electrode 350 and the second drain electrode 370.

The fifth insulating layer 160 may protect the first thin film transistor 200 and the second thin film transistor 300. The fifth insulating layer 160 may be formed of an insulating inorganic material such as silicon nitride (SiNx) or silicon oxide (SiOx) and besides, may be formed of an insulating organic material, but the embodiments of the present disclosure are not limited thereto.

The fifth insulating layer 160 may have a hole to electrically connect the second thin film transistor 300 and a connection electrode 180 or a first electrode 510. The fifth insulating layer 160 may be omitted depending on the structure, type, etc. of a thin film transistor.

A protective layer 170 may be disposed on the fifth insulating layer 160. For example, the protective layer 170 may be an insulating layer or a planarization layer, but the embodiments of the present disclosure are not limited thereto. The protective layer 170 may protect a thin film transistor which is disposed under the protective layer 170, and may reduce or planarize steps caused by various patterns. For example, the protective layer 170 may insulate components which are disposed on and under the protective layer 170. For example, the protective layer 170 may be disposed as a single layer but may be disposed as a plurality of layers (that is, at least two layers), and the embodiments of the present disclosure are not limited thereto.

As the display apparatus 1000 evolves to higher resolution, the number of various signal wirings increases. Therefore, since it is difficult to dispose all wirings at one layer while securing minimum gaps, an additional layer may be configured. Because a margin in disposing wirings is secured due to the presence of the additional layer, it is possible to more easily perform design for disposing wirings/electrodes. As a dielectric material is used as a planarization layer which is configured with a multilayer, the protective layer 170 may be used to form capacitance between metal layers.

When the protective layer 170 is disposed as two layers, the protective layer 170 may include a first protective layer 171 and a second protective layer 172. For example, the first protective layer 171 may be a sixth insulating layer, but the embodiments of the present disclosure are not limited thereto. For example, the second protective layer 172 may be a seventh insulating layer, but the embodiments of the present disclosure are not limited thereto. For example, a hole may be formed in the first protective layer 171, and the connection electrode 180 may be disposed in the hole. The second protective layer 172 which has a hole may be disposed on the first protective layer 171 and the connection electrode 180. The first electrode 510 may be disposed in the hole of the second protective layer 172. Accordingly, the first thin film transistor 300 and the first electrode 510 may be electrically connected through the connection electrode 180.

One end (one portion or one side) of the connection electrode 180 may be connected to the second thin film transistor 300, and the other end (the other portion or the other side) of the connection electrode 180 may be connected to the first electrode 510.

The connection electrode 180 may be further disposed on the first protective layer 171.

The connection electrode 180 may be formed as a single layer or a multilayer made of any one or an alloy of molybdenum (Mo), copper (Cu), titanium (Ti), aluminum (Al) chromium (Cr), gold (Au), nickel (Ni), neodymium (Nd), tungsten (W) and transparent conductive oxide (TCO), but the embodiments of the present disclosure are not limited thereto. For example, the connection electrode 180 may be made of a three-layered structure of titanium (Ti)/aluminum (Al)/titanium (Ti) as conductive metal materials.

The connection electrode 180 may be a first connection electrode, but the embodiments of the present disclosure are not limited thereto. The connection electrode 180 may be omitted on the basis of the structure, type, etc. of the display apparatus 1000.

The second protective layer 172 may be disposed on the first protective layer 171 and the connection electrode 180.

The first protective layer 171 and the second protective layer 172 may be formed of at least one material among organic insulating materials such as benzocyclobutene (BCB), acryl resin, epoxy resin, phenolic resin, polyamide resin and polyimide resin, but the embodiments of the present disclosure are not limited thereto.

The protective layer 170 of the display apparatus 1000 may be disposed as three layers in consideration of the disposition of electrodes, but the embodiments of the present disclosure are not limited thereto.

A light emitting element layer 500 may be disposed on the protective layer 170 or the second protective layer 172. The light emitting element layer 500 may include the first electrode 510, an organic layer 540 and a second electrode 550.

The first electrode 510 may be disposed on the protective layer 170. The first electrode 510 may supply holes to the organic layer 540, and may be made of a conductive material which has high work function. The first electrode 510 may be an anode electrode, but the embodiments of the present disclosure are not limited thereto.

When the display apparatus 1000 is a top emission type, the first electrode 510 as a reflective electrode which reflects light may be disposed using an opaque conductive material. The first electrode 510 may be formed of at least one among silver (Ag), aluminum (Al), gold (Au), molybdenum (Mo), tungsten (W), chromium (Cr) and alloys thereof, but the embodiments of the present disclosure are not limited thereto. For example, the first electrode 510 may be made of a three-layered structure of silver (Ag)/lead (Pd)/copper (Cu), but is not limited thereto. Alternatively, the first electrode 510 may further include a transparent conductive material layer with high work function, such as indium tin oxide (ITO).

When the display apparatus 1000 is a bottom emission type, the first electrode 510 may be disposed using a transparent conductive material which transmits light. For example, the first electrode 510 may be formed of at least one of indium tin oxide (ITO) and indium zinc oxide (IZO), but the embodiments of the present disclosure are not limited thereto.

A bank 520 may be disposed on the first electrode 510 and the protective layer 170.

The bank 520 may distinguish a plurality of subpixels, minimize or at least reduce a light blurring phenomenon, and prevent or at least reduce color mixing occurring at various viewing angles. The bank 520 may define (or distinguish) a light emitting part which emits light and a non-light emitting part which does not emit light. The bank 520 may be disposed in the non-light emitting part. The bank 520 may have a bank hole which exposes the light emitting part and the first electrode 510.

The bank 520 may be made of at least one material among an inorganic insulating material such as silicon nitride (SiNx) and silicon oxide (SiOx), an organic insulating material such as benzocyclobutene (BCB), acrylic resin, epoxy resin, phenolic resin, polyamide resin and polyimide resin and a photosensitive agent including black pigment, but the embodiments of the present disclosure are not limited thereto.

The bank 520 may be formed to be black or colored. For example, when the bank 520 includes a black material, it is possible to prevent external light, internal reflected light and/or scattered light scattered from the side surface of the first electrode 510 from being incident on a thin film transistor, and it is possible to solve a problem that the luminance of a display apparatus decreases. The bank 520 may be disposed to cover the ends (or partial areas) of the first electrode 510.

At least one spacer 530 may be disposed on the bank 520.

The spacer 530 may prevent or at least reduce damage to the organic layer 540 during a processing process of the organic layer 540, and may minimize or at least reduce breakage of the display apparatus 1000 due to external impacts.

The spacer 530 may be formed of the same material as the bank 520, and may be formed simultaneously with the bank 520 or may be formed through a separate process. For example, the spacer 530 may be formed to be transparent, black or colored. Alternatively, the spacer 530 may include a transparent material, a black material or a colored material, but the embodiments of the present disclosure are not limited thereto.

The thickness of the spacer 530 may be equal to or larger than the thickness of the bank 520. The thickness of the spacer 530 may be 1 µm to 2 µm, but the embodiments of the present disclosure are not limited thereto.

The organic layer 540 may be disposed on the first electrode 510 and the bank 520. The organic layer 540 may include an emitting layer (EML) for emitting light of a specific color in each of the plurality of subpixels. The emitting layer may be a layer which emits light. For example, holes generated in the first electrode 510 and electrons generated in the second electrode 550 may be injected into the emitting layer. Holes and electrons injected into the emitting layer may combine to generate excitons. Light may be generated when the generated excitons fall from an excited state to a ground state.

For example, the emitting layer may include one of a red emitting layer which emits red, a green emitting layer which emits green, a blue emitting layer which emits blue, and a white emitting layer which emits white. When the organic layer 540 includes the white emitting layer, a color filter for converting white light from the white emitting layer into light of another color may be disposed on the organic layer 540. The organic layer 540 may further include, in addition to the emitting layer, a hole injection layer (HIL), a hole transport layer (HTL), an electron blocking layer (EBL), a hole blocking layer (HBL), an electron transport layer (ETL) and an electron injection layer (EIL), but the embodiments of the present disclosure are not limited thereto.

The emitting layer of the organic layer 540 may be disposed in each of the plurality of subpixels, and at least one of the hole injection layer (HIL), the hole transport layer (HTL), the electron blocking layer (EBL), the hole blocking layer (HBL), the electron transport layer (ETL) and the electron injection layer (EIL) of the organic layer 540 may be disposed throughout a display area.

The organic layer 540 of the display apparatus 1000 according to the embodiment of the present disclosure may be an emitting unit. At least one emitting unit may be disposed. For example, a stack structure may be configured by stacking a plurality of emitting units between the first electrode 510 and the second electrode 550. In this case, a charge generation layer may be further disposed between the plurality of emitting units. A plurality of emitting units may be disposed in each subpixel.

The emitting unit will be described later in detail with reference to FIG. 9.

The second electrode 550 may be disposed on the organic layer 540. The second electrode 550 may supply electrons to the organic layer 540, and may be made of a conductive material which has low work function. The second electrode 550 may be a cathode electrode, but the embodiments of the present disclosure are not limited thereto.

When the display apparatus 1000 is a top emission type, the second electrode 550 may be disposed using a transparent conductive material which transmits light. For example, the second electrode 550 may be formed of at least one of indium tin oxide (ITO) and indium zinc oxide (IZO), but the embodiments of the present disclosure are not limited thereto. In addition, the second electrode 550 may be disposed using a translucent conductive material which transmits light. For example, the second electrode 550 may be formed of at least one among alloys such as LiF/Al, CsF/Al, Mg:Ag, Ca/Ag, Ca:Ag, LiF/Mg:Ag, LiF/Ca/Ag and LiF/Ca:Ag, but the embodiments of the present disclosure are not limited thereto.

When the display apparatus 1000 is a bottom emission type, the second electrode 550 as a reflective electrode which reflects light may be disposed using an opaque conductive material. For example, the second electrode 550 may be formed of at least one among silver (Ag), aluminum (Al), gold (Au), molybdenum (Mo), tungsten (W), chromium (Cr) and alloys thereof, but the embodiments of the present disclosure are not limited thereto.

An encapsulation part 600 may be disposed on the second electrode 550. The encapsulation part 600 may protect the organic layer 540 from external moisture, oxygen or foreign substances. For example, in order to prevent oxidation of a light emitting material and an electrode material, the encapsulation part 600 may prevent penetration of oxygen and moisture from the outside.

The encapsulation part 600 may include a first encapsulation layer 610, a second encapsulation layer 620 and a third encapsulation layer 630 which block penetration of moisture or oxygen. The first encapsulation layer 610, the second encapsulation layer 620 and the third encapsulation layer 630 may have a structure in which they are alternately stacked, but the embodiments of the present disclosure are not limited thereto.

The encapsulation part 600 may be made of a transparent material so that light emitted from the emitting layer may be transmitted.

The first encapsulation layer 610 and the third encapsulation layer 630 may be made of at least one inorganic material among silicon nitride (SiNx), silicon oxide (SiOx) and aluminum oxide (AlyOz), but are not limited thereto. The first encapsulation layer 610 and the third encapsulation layer 630 may be formed using a vacuum deposition method such as chemical vapor deposition (CVD) or atomic layer deposition (ALD), but are not limited thereto.

The first encapsulation layer 610 and the third encapsulation layer 630 may be formed as at least two layers. For example, the first encapsulation layer 610 may be made of a three-layered structure of silicon oxide (SiOx)/silicon nitride (SiNx)/silicon oxide (SiOx), but is not limited thereto. For another example, the first encapsulation layer 610 may be made of a four-layered structure of silicon oxide (SiOx)/silicon nitride (SiNx)/silicon oxide (SiOx)/silicon oxide (SiOx), but is not limited thereto.

The second encapsulation layer 620 may cover foreign substances or particles that may occur during a manufacturing process of the display apparatus 1000. In addition, the second encapsulation layer 620 may planarize the surface of the first encapsulation layer 610. For example, the second encapsulation layer 620 may be a particle cover layer, but is not limited to the term.

The second encapsulation layer 620 may be an organic material, for example, a polymer based on silicon oxycarbon (SiOCz), epoxy, polyimide, polyethylene or acrylate, but is not limited thereto.

The second encapsulation layer 620 may be made of a thermosetting material or a photocurable material which is cured by heat or light.

The second encapsulation layer 620 may be formed in various ways such as inkjet coating or slit coating, but the embodiments of the present disclosure are not limited thereto. For example, by spraying or dropping a liquid organic material onto the substrate 110 formed with the first encapsulation layer 610 in the display area using an inkjet device or a nozzle coating device, the second encapsulation layer 620 may be formed on the first encapsulation layer 610. As a spray nozzle moves over an application area (or a nozzle is fixed and an object moves), an organic material in a fluid state may be formed in the application area.

Since a material configuring the second encapsulation layer 620 has low viscosity properties, the material may be in a high-density liquid-like state until it is cured. A dam may be disposed to solve a problem that the second encapsulation layer 620 spreads (or flows) to a non-display area.

A touch part 700 may be disposed on the encapsulation part 600.

The touch part 700 may include a first touch electrode 740_R, a first touch connection electrode 720, a second touch electrode, and a second touch connection electrode 740_C.

Portions of the first touch electrode 740_R, the first touch connection electrode 720, the second touch electrode and the second touch connection electrode 740_C may be disposed to overlap the bank 520.

The first touch electrode 740_R, the second touch electrode, the first touch connection electrode 720 and the second touch connection electrode 740_C may be formed as a mesh pattern which is formed as metal lines intersect each other. The mesh pattern may have a diamond shape. In addition, the mesh pattern may have a square, pentagonal, hexagonal, circular or oval shape, but is not limited thereto.

The first touch electrode 740_R, the second touch electrode, the first touch connection electrode 720 and the second touch connection electrode 740_C may be disposed using an opaque conductive material which has low resistance. For example, the first touch electrode 740_R, the second touch electrode, the first touch connection electrode 720 and the second touch connection electrode 740_C may be formed as a single layer or a multilayer made of any one or an alloy of molybdenum (Mo), copper (Cu), titanium (Ti), aluminum (Al), chromium (Cr), gold (Au), nickel (Ni), neodymium (Nd), tungsten (W) and transparent conductive oxide (TCO), but are not limited thereto. For example, the first touch electrode 740_R, the second touch electrode, the first touch connection electrode 720 and the second touch connection electrode 740_C may be made of a three-layered structure of titanium (Ti)/aluminum (Al)/titanium (Ti) as conductive metal materials, but are not limited thereto.

The first touch electrode 740_R, the second touch electrode, the first touch connection electrode 720 and the second touch connection electrode 740_C may be made of the same material as the first source electrode 250, the first drain electrode 270, the second source electrode 350 and the second drain electrode 370, but the embodiments of the present disclosure are not limited thereto.

A buffer layer 710 may be disposed on the encapsulation part 600. The buffer layer 710 may block a chemical solution (such as developer or etchant) used during a manufacturing process of the touch part 700 or moisture from the outside from penetrating into the light emitting element layer 500 which includes an organic material. In addition, the buffer layer 710 may prevent a problem that a plurality of touch sensor metals disposed on the buffer layer 710 are cut off due to external impacts, and may block an interference signal which is generated when driving the touch part 700. For example, the buffer layer 710 may be a touch buffer layer, a second buffer layer or an eighth insulating layer, but the embodiments of the present disclosure are not limited thereto.

The buffer layer 710 may be made of at least one material among an inorganic insulating material such as silicon nitride (SiNx) or silicon oxide (SiOx) and an organic insulating material such as benzocyclobutene (BCB), acrylic resin, epoxy resin, phenolic resin, polyamide resin and polyimide resin, but is not limited thereto.

The first touch connection electrode 720 may be disposed on the buffer layer 710.

For example, the first touch connection electrode 720 may be disposed between first touch electrodes 740_R which are adjacent to each other in a first direction (or the X-axis direction as shown in FIG. 1). The first touch connection electrode 720 may electrically connect a plurality of first touch electrodes 740_R which are disposed to be spaced apart from each other and be adjacent to each other in the first direction (or the X-axis direction as shown in FIG. 1), but is not limited thereto.

The first touch connection electrode 720 may be disposed to overlap the second touch connection electrode 740_C which connects second touch electrodes adjacent to each other in a second direction (or the Y-axis direction as shown in FIG. 1). Since the first touch connection electrode 720 and the second touch connection electrode 740_C are formed at different layers, they may be electrically insulated from each other. For example, the first touch connection electrode 720 may be a connection electrode or a second connection electrode, but the embodiments of the present disclosure are not limited thereto. For example, the second touch connection electrode 740_C may be a third connection electrode, but the embodiments of the present disclosure are not limited thereto.

An insulating layer 730 may be disposed on the buffer layer 710 and the first touch connection electrode 720. For example, the insulating layer 730 may be a touch insulating layer or a ninth insulating layer, but the embodiments of the present disclosure are not limited thereto.

The insulating layer 730 may include a hole to electrically connect the first touch electrode 740_R and the first touch connection electrode 720. For example, the insulating layer 730 may electrically insulate the second touch electrode and the second touch connection electrode 740_C. For example, the insulating layer 730 may be an organic material, for example, a polymer based on silicon oxycarbon (SiOCz), epoxy, polyimide, polyethylene or acrylate, but is not limited thereto. The insulating layer 730 may be made of a thermosetting material or a photocurable material which is cured by heat or light.

When the insulating layer 730 is made of an inorganic material, the insulating layer 730 is disposed along sharp steps and curves (or curved portions) of various components disposed under the insulating layer 730. Therefore, a problem may rise in that, since the sharp steps and curves (or curved portions) are not covered, some of internal components of the display apparatus are visible from the outside. This reduces aesthetics for users because the users may perceive the some of the internal components as defects such as stains. In addition, an insulating layer made of an inorganic material is less effective in blocking moisture and oxygen penetrating from outside a display apparatus than an insulating layer made of an organic material. Furthermore, the insulating layer made of an inorganic material may not cover foreign substances or particles that may be generated during a manufacturing process of a display apparatus. When the insulating layer 730 is made of an organic material, it is possible to solve a problem that a crack or a cut-off occurs in a wiring due to mechanical stress in a bending area during or after the bending process of a plate in the manufacturing process of a display apparatus including the bending area.

The first touch electrode 740_R, the second touch electrode and the second touch connection electrode 740_C may be disposed on the insulating layer 730.

The first touch electrode 740_R and the second touch electrode may be disposed to be spaced apart from each other by a predetermined distance. Two or more first touch electrodes 740_R adjacent to each other in the first direction (or the X-axis direction as shown in FIG. 1) may be formed to be spaced apart from each other. The two or more first touch electrodes 740_R adjacent to each other in the first direction (or the X-axis direction as shown in FIG. 1) may be connected to the first touch connection electrode 720 which is disposed between the plurality of first touch electrodes 740_R. For example, a plurality of first touch electrodes 740_R adjacent to each other may be connected to the first touch connection electrode 720 through holes in the insulating layer 730.

Second touch electrodes adjacent in the second direction (or the Y-axis direction as shown in FIG. 1) may be connected by the second touch connection electrode 740_C. The second touch electrode and the second touch connection electrode 740_C may be formed at the same layer. For example, the second touch connection electrode 740_C may be disposed between a plurality of second touch electrodes at the same layer as the second touch electrodes. The second touch connection electrode 740_C may be formed to extend from the second touch electrode.

The first touch electrode 740_R, the second touch electrode and the second touch connection electrode 740_C may be formed through the same process.

A protective layer 750 may be disposed on the first touch electrode 740_R, the second touch electrode and the second touch connection electrode 740_C. For example, the protective layer 750 may be a planarization layer, a touch planarization layer, a tenth insulating layer or a third protective layer, but the embodiments of the present disclosure are not limited thereto.

A touch driving circuit may receive a touch detection signal from the first touch electrode 740_R. The touch driving circuit may receive a touch driving signal from the second touch electrode. The touch driving circuit may detect a user's touch using the mutual capacitance between the plurality of first touch electrodes 740_R and second touch electrodes. For example, when a touch is made on the display apparatus 1000, a change in capacitance between the first touch electrode 740_R and the second touch electrode may occur. The touch driving circuit may detect touch coordinates by detecting the change in capacitance.

FIG. 9 is a cross-sectional view of a light emitting part according to an embodiment of the present disclosure.

Description for a light emitting unit shown in FIG. 9 may be applied the same to FIG. 8.

A stack structure may be configured by stacking a plurality of light emitting units between a first electrode 510 and a second electrode 550. Although two light emitting units are shown in FIG. 9, a plurality of light emitting units the number of which is two or more may be configured, and the embodiments of the present disclosure are not limited thereto.

Referring to FIG. 9, the light emitting unit may include a first light emitting unit 541 and a second light emitting unit 542, and a charge generation layer (CGL) 60 may be additionally disposed between a plurality of light emitting units. For example, the charge generation layer 60 may be disposed between the first light emitting unit 541 and the second light emitting unit 542.

A light emitting element layer configured with a plurality of light emitting units may have improved luminous efficiency and longer lifespan compared to a light emitting element layer configured with one organic layer or one light emitting unit. For example, since a plurality of light emitting units are connected in series to meet the condition of light emission amount or light intensity required in a display apparatus, the stress, current concentration due to resistance or degradation of a single organic layer or a single light emitting unit may be dispersed. Therefore, because the efficiency and lifespan of each light emitting unit are improved and increased, the reliability of the display apparatus may be improved.

The charge generation layer (CGL) 60 may be disposed between a plurality of light emitting units to control charge balance. The charge generation layer 60 may include an N-type charge generation layer (N-CGL) and a P-type charge generation layer (P-CGL). The N-type charge generation layer (N-CGL) serves to inject electrons into a light emitting unit. The N-type charge generation layer (N-CGL) may be made of an organic layer doped with an alkali metal such as lithium (Li), sodium (Na), potassium (K) or cesium (Cs) or an alkaline earth metal such as magnesium (Mg), strontium (Sr), barium (Ba) or radium (Ra), but is not limited thereto. The P-type charge generation layer (P-CGL) serves to inject holes into a light emitting unit. The P-type charge generation layer (P-CGL) may be made of an organic layer including a P-type dopant, but is not limited thereto.

In the present disclosure, a pixel P disposed in a display area AA may further include a plurality of subpixels (for example, first, second and third subpixels SP-1, SP-2 and SP-3, but not limited thereto). The first, second and third subpixels SP-1, SP-2 and SP-3 are individual units which emit light. A plurality of subpixels may include red, green, blue and/or white subpixels, and are not limited thereto.

The first subpixel SP-1, the second subpixel SP-2 and the third subpixel SP-3 may emit light of different colors. Each of the first subpixel SP-1, the second subpixel SP-2 and the third subpixel SP-3 may emit at least one of red, green and blue. In the present disclosure, it will be described that the first subpixel SP-1 emits red, the second subpixel SP-2 emits green and the third subpixel SP-3 emits blue.

The first light emitting unit 541 may be disposed on a first electrode 510. The first light emitting unit 541 may include a first hole transport layer (HTL) 51, a first emitting layer (EML) 52 and a first electron transport layer (ETL) 53. The first light emitting unit 541 may further include a hole injection layer (HIL) and/or an electron blocking layer (EBL). The hole injection layer (HIL) and the electron blocking layer (EBL) may be disposed between the first electrode 510 and the first hole transport layer (HTL) 51.

The hole injection layer (HIL) may be disposed on the first electrode 510. The hole injection layer (HIL) may serve to smoothly inject holes from the first electrode 510 into the first hole transport layer (HTL) 51.

The first hole transport layer (HTL) 51 may be disposed on the first electrode 510 or the hole injection layer (HIL). The first hole transport layer (HTL) 51 may supply holes from the first electrode 510 or the hole injection layer (HIL), to the first emitting layer (EML) 52. The first hole transport layer (HTL) 51 may be configured by applying at least two layers or at least two materials.

The first emitting layer (EML) 52 may be disposed on the first hole transport layer (HTL) 51. In the first emitting layer (EML) 52, light may be generated as holes supplied through the first hole transport layer (HTL) 51 and electrons supplied through the first electron transport layer (ETL) 53 are recombined. The first emitting layer (EML) 52 may further include a first auxiliary emitting layer on or under the first emitting layer (EML) 52.

In the first emitting layer (EML) 52, a different emitting layer may be disposed for each subpixel. For example, the first emitting layer (EML) 52 may include a first red emitting layer 52-R, a first green emitting layer 52-G and a first blue emitting layer 52-B.

The first red emitting layer 52-R which is disposed in the first subpixel SP-1 may emit red. The wavelength band of light emitted from the first red emitting layer 52-R may be in the range of 640 nm to 700 nm.

The first green emitting layer 52-G which is disposed in the second subpixel SP-2 may emit green. The wavelength band of light emitted from the first green emitting layer 52-G may be in the range of 510 nm to 580 nm.

The first blue emitting layer 52-B which is disposed in the third subpixel SP-3 may emit blue. The wavelength band of light emitted from the first blue emitting layer 52-B may be in the range of 440 nm to 480 nm.

The first emitting layer (EML) 52 may be configured with at least one host and at least one dopant. Alternatively, the first emitting layer (EML) 52 may be configured with a mixed host in which at least two hosts are mixed and at least one dopant. In the mixed host, a host with hole transport properties and a host with electron transport properties may be included. When the mixed host is configured, the charge balance of an emitting layer may be controlled, and thus, the efficiency of the emitting layer may be improved. The dopant may be configured with a fluorescent dopant or a phosphorescent dopant.

The first electron transport layer (ETL) 53 may be disposed on the first emitting layer (EML) 52. The first electron transport layer (ETL) 53 may supply electrons received from the charge generation layer 60, to the first emitting layer (EML) 52. Therefore, in the first emitting layer (EML) 52, light may be generated since holes supplied through the first hole transport layer (HTL) 51 and electrons supplied through the first electron transport layer (ETL) 53 are recombined.

The first electron transport layer (ETL) 53 may be configured by applying at least two layers or at least two materials. An electron injection layer (EIL) may be further configured on the first electron transport layer (ETL) 53.

In order to improve the efficiency of the first emitting layer (EML) 52, an electron blocking layer (EBL) and a hole blocking layer (HBL) may be further included. The electron blocking layer (EBL) may be disposed between the first hole transport layer (HTL) 51 and the first emitting layer (EML) 52, and the hole blocking layer (HBL) may be disposed between the first electron transport layer (ETL) 53 and the first emitting layer (EML) 52.

The charge generation layer 60 may be disposed on the first light emitting unit 541. The charge generation layer 60 may include the N-type charge generation layer (N-CGL) which supplies electrons to the first light emitting unit 541 and the P-type charge generation layer (P-CGL) which supplies holes to the second light emitting unit 542. The N-type charge generation layer (N-CGL) may be disposed adjacent to the first light emitting unit 541, and the P-type charge generation layer (P-CGL) may be disposed adjacent to the second light emitting unit 542. For example, the N-type charge generation layer (N-CGL) may be disposed on the first light emitting unit 541, and the P-type charge generation layer (P-CGL) may be disposed on the N-type charge generation layer (N-CGL).

The second light emitting unit 542 may be disposed on the charge generation layer 60. The second light emitting unit 542 may include a second hole transport layer (HTL) 54, a second emitting layer (EML) 55 and a second electron transport layer (ETL) 56. The second light emitting unit 542 may further include a hole injection layer (HIL) and/or an electron blocking layer (EBL). The hole injection layer (HIL) and the electron blocking layer (EBL) may be disposed between the charge generation layer 60 and the second hole transport layer (HTL) 54.

The second hole transport layer (HTL) 54 may be disposed on the charge generation layer 60. The second hole transport layer (HTL) 54 may supply holes from the P-type charge generation layer (P-CGL) of the charge generation layer 60, to the second emitting layer (EML) 55. The second hole transport layer (HTL) 54 may be configured by applying at least two layers or at least two materials.

The second emitting layer (EML) 55 may be disposed on the second hole transport layer (HTL) 54. In the second emitting layer (EML) 55, light may be generated as holes supplied through the second hole transport layer (HTL) 54 and electrons supplied through the second electron transport layer (ETL) 56 are recombined.

In the second emitting layer (EML) 55, a different emitting layer may be disposed for each subpixel. For example, the second emitting layer (EML) 55 may include a second red emitting layer 55-R, a second green emitting layer 55-G and a second blue emitting layer 55-B.

The second red emitting layer 55-R which is disposed in the first subpixel SP-1 may emit red. The wavelength band of light emitted from the second red emitting layer 55-R may be in the range of 600 nm to 700 nm.

The second green emitting layer 55-G which is disposed in the second subpixel SP-2 may emit green. The wavelength band of light emitted from the second green emitting layer 55-G may be in the range of 510 nm to 590 nm.

The second blue emitting layer 55-B which is disposed in the third subpixel SP-3 may emit blue. The wavelength band of light emitted from the second blue emitting layer 55-B may be in the range of 440 nm to 480 nm. The second emitting layer (EML) 55 may further include a second auxiliary emitting layer on or under the second emitting layer (EML) 55.

The second emitting layer (EML) 55 may be configured with at least one host and at least one dopant. Alternatively, the second emitting layer (EML) 55 may be configured with a mixed host in which at least two hosts are mixed and at least one dopant. In the mixed host, a host with hole transport properties and a host with electron transport properties may be included. When the mixed host is configured, the charge balance of an emitting layer may be controlled, and thus, the efficiency of the emitting layer may be improved. The dopant may be configured with a fluorescent dopant or a phosphorescent dopant.

The second electron transport layer (ETL) 56 may be disposed on the second emitting layer (EML) 55. The second electron transport layer (ETL) 56 may supply electrons received from a second charge generation layer, to the second emitting layer (EML) 55. Therefore, in the second emitting layer (EML) 55, light may be generated since holes supplied through the second hole transport layer (HTL) 54 and electrons supplied through the second electron transport layer (ETL) 56 are recombined.

The second electron transport layer (ETL) 56 may be configured by applying at least two layers or at least two materials. An electron injection layer (EIL) may be further configured on the second electron transport layer (ETL) 56.

In order to improve the efficiency of the second emitting layer (EML) 55, an electron blocking layer (EBL) and a hole blocking layer (HBL) may be further included. The electron blocking layer (EBL) may be disposed between the second hole transport layer (HTL) 54 and the second emitting layer (EML) 55, and the hole blocking layer (HBL) may be disposed between the second electron transport layer (ETL) 56 and the second emitting layer (EML) 55.

A display apparatus according to an embodiment of the present disclosure may be described as follows.

The display apparatus according to the embodiment of the present disclosure may include a display panel including a plurality of non-bending areas and a bending area disposed between the plurality of non-bending areas; a first protection member disposed on the display panel at least in the bending area; a second protection member disposed on the first protection member; and a third protection member disposed on the second protection member.

In the display apparatus according to the embodiment of the present disclosure, the second protection member may cover one end of the first protection member.

In the display apparatus according to the embodiment of the present disclosure, one end of the second protection member may contact at least a portion of the display panel.

In the display apparatus according to the embodiment of the present disclosure, the first protection member and the second protection member may be disposed along the bending area, and the third protection member may cover a side surface of the bending area.

In the display apparatus according to the embodiment of the present disclosure, the second protection member and the third protection member may be made of different materials.

In the display apparatus according to the embodiment of the present disclosure, the second protection member may include an ultraviolet blocking material.

In the display apparatus according to the embodiment of the present disclosure, the third protection member may include an ultraviolet transmitting material.

In the display apparatus according to the embodiment of the present disclosure, the first protection member and the third protection member may include resin.

In the display apparatus according to the embodiment of the present disclosure, the second protection member may include a black material.

In the display apparatus according to the embodiment of the present disclosure, the second protection member may have adhesive properties.

In the display apparatus according to the embodiment of the present disclosure, a tensile modulus of the first protection member may be different from a tensile modulus of the third protection member.

In the display apparatus according to the embodiment of the present disclosure, the tensile modulus of the third protection member may be equal to or smaller than the tensile modulus of the first protection member.

The display apparatus according to the embodiment of the present disclosure may include a polarizer disposed on the display panel and contacting one end of the first protection member and one end of the second protection member.

The display apparatus according to the embodiment of the present disclosure may include a flexible film disposed to be spaced apart from one end of the first protection member and one end of the second protection member.

In the display apparatus according to the embodiment of the present disclosure, the third protection member may cover the bending area and a portion of the plurality of non-bending areas.

The display apparatus according to the embodiment of the present disclosure may further include a front surface member contacting the third protection member.

In the display apparatus according to the embodiment of the present disclosure, the second protection member may overlap a support member which is disposed on a rear surface of the display panel.

In the display apparatus according to the embodiment of the present disclosure, the display panel may include a flexible display panel (in other words, the display panel may be a flexible display panel).

In the display apparatus according to the embodiment of the present disclosure, the display panel may further include a thin film transistor and a light emitting element layer, and the light emitting element layer may include an organic material or an inorganic material.

In the display apparatus according to the embodiment of the present disclosure, the light emitting element layer may include a plurality of light emitting parts, and the light emitting element layer may include a charge generation layer between the plurality of light emitting parts.

In the display apparatus according to the embodiment of the present disclosure, the tensile modulus of the third protection member may be greater than the tensile modulus of the first protection member.

A display apparatus according to one or more embodiments of the present disclosure may be applied to or included in a mobile device, a video phone, a smart watch, a watch phone, a wearable apparatus, a foldable apparatus, a rollable apparatus, a bendable apparatus, a flexible apparatus, a curved apparatus, a sliding apparatus, a variable apparatus, an electronic notebook, an electronic book, a portable multimedia player (PMP), a personal digital assistant (PDA), a MP3 player, a mobile medical apparatus, a desktop PC, a laptop PC, a netbook computer, a workstation, a navigation, a vehicle navigation, a vehicle display apparatus, a vehicle apparatus, a theater apparatus, a theater display apparatus, a television, a wallpaper apparatus, a signage apparatus, a game apparatus, a laptop computer, a monitor, a camera, a camcorder, and a home appliance. In addition, the display apparatus of one or more embodiments of the present disclosure may be applied to or included in an organic light emitting lighting apparatus or an inorganic light emitting lighting apparatus.

Although the example embodiments of the present disclosure have been described in detail with reference to the accompanying drawings, the present disclosure is not limited thereto and may be embodied in many different forms without departing from the technical concept of the present disclosure. Therefore, the example embodiments of the present disclosure are provided for illustrative purposes only but not intended to limit the technical concept of the present disclosure. The scope of the technical concept of the present disclosure is not limited thereto. Therefore, it should be understood that the above-described example embodiments are illustrative in all aspects and do not limit the present disclosure.

## Claims

1. A display apparatus comprising:
a display panel (1) including at least two non-bending areas (NBA1, NBA2) and a bending area (BA) between two of the at least two non-bending areas;
a first protection member (8) disposed on at least the bending area (BA);
a second protection member (9) disposed on the first protection member (8); and
a third protection member (11) disposed on the second protection member (9),
wherein the first protection member (8), the second protection member (9), and the third protection member (11) are disposed in that order from the inside to the outside of the display apparatus,
wherein the first protection member (8) includes or is composed of resin,
wherein the third protection member (11) includes or is composed of resin,
wherein the second protection member (9) is composed of or includes an ultraviolet blocking material and is arranged and/or configured to block ultraviolet light from being irradiated to the first protection member (8),
wherein a tensile modulus of the first protection member (8) is different from a tensile modulus of the third protection member (11).

2. The display apparatus of claim 1, wherein the second protection member (9) covers at least one end of the first protection member (8), in particular, a side surface of the at least one end of the first protection member (8).

3. The display apparatus of any one of the preceding claims, wherein one end of the second protection member (9) contacts at least a portion of the display panel (1), and/or wherein at least one end of the second protection member (9) is disposed in one of the at least two non-bending areas (NBA1, NBA2) or two ends of the second protection member (9) are disposed in the at least two non-bending areas (NBA1, NBA2), respectively.

4. The display apparatus of any one of the preceding claims, wherein the first protection member (8) and the second protection member (9) extend from one side surface to the other side surface of the bending area (BA), and the third protection member covers at least one side surface of the bending area (BA).

5. The display apparatus of any one of the preceding claims, wherein the second protection member (9) and the third protection member (11) are made of different materials.

6. The display apparatus of any one of the preceding claims, wherein the second protection member (9) includes or is composed of a black material.

7. The display apparatus of any one of the preceding claims, wherein the third protection member (11) includes or is composed of an ultraviolet transmitting material.

8. The display apparatus of any one of the preceding claims, wherein the tensile modulus of the third protection member (11) is less than the tensile modulus of the first protection member (8) or the tensile modulus of the third protection member (11) is greater than the tensile modulus of the first protection member (8).

9. The display apparatus of any one of the preceding claims, wherein the second protection member (9) includes an adhesive material and/or has adhesive properties.

10. The display apparatus of any one of the preceding claims, further comprising a polarizer (6) on the display panel (1), the polarizer (6) contacting one end of the first protection member (8) and one end of the second protection member (9).

11. The display apparatus of any one of the preceding claims, further comprising a flexible film (2) spaced apart from one end of the first protection member (8) and one end of the second protection member (9).

12. The display apparatus of any one of the preceding claims, wherein the third protection member (11) covers the bending area (BA) and a portion of the at least two non-bending areas (NBA1, NBA2).

13. The display apparatus of any one of the preceding claims, further comprising a front surface member (7) disposed on a front side of the display panel (1) and contacting the third protection member (11).

14. The display apparatus of any one of the preceding claims, wherein the display panel (1) is a flexible display panel, and/or
wherein the display panel further (1) includes a light emitting element layer (500), the light emitting element layer including an organic material or an inorganic material.

15. The display apparatus of any one of the preceding claims, further including a support member (4) disposed on a rear side of the display panel (1),
wherein at least one end of the second protection member (9) overlaps the support member (4) and/or, when the display panel (1) is bent, the support member (4) is sandwiched between the two ends of the second protection member (9) disposed in the at least two non-bending areas (NBA1, NBA2), respectively.

## Patentansprüche

1. Anzeigevorrichtung, die Folgendes umfasst:
eine Anzeigetafel (1), die mindestens zwei Nichtbiegeflächen (NBA1, NBA2) und eine Biegefläche (BA) zwischen zwei der mindestens zwei Nichtbiegeflächen enthält;
ein erstes Schutzelement (8), das mindestens auf der Biegefläche (BA) angeordnet ist;
ein zweites Schutzelement (9), das auf dem ersten Schutzelement (8) angeordnet ist; und
ein drittes Schutzelement (11), das auf dem zweiten Schutzelement (9) angeordnet ist,
wobei das erste Schutzelement (8), das zweite Schutzelement (9) und das dritte Schutzelement (11) in dieser Reihenfolge von der Innenseite zur Außenseite der Anzeigevorrichtung angeordnet sind,
wobei das erste Schutzelement (8) Harz enthält oder daraus gebildet ist,
wobei das dritte Schutzelement (11) Harz enthält oder daraus gebildet ist,
wobei das zweite Schutzelement (9) aus einem Ultraviolett-Sperrmaterial gebildet ist oder es enthält und derart angeordnet und/oder konfiguriert ist, zu blockieren, dass ultraviolettes Licht zum ersten Schutzelement (8) ausgestrahlt wird, und
wobei ein Zugmodul des ersten Schutzelements (8) von einem Zugmodul des dritten Schutzelements (11) verschieden ist.

2. Anzeigevorrichtung nach Anspruch 1, wobei das zweite Schutzelement (9) mindestens ein Ende des ersten Schutzelements (8), insbesondere eine Seitenoberfläche des mindestens einen Endes des ersten Schutzelements (8) abdeckt.

3. Anzeigevorrichtung nach einem der vorhergehenden Ansprüche, wobei ein Ende des zweiten Schutzelements (9) mindestens einen Abschnitt der Anzeigetafel (1) berührt und/oder mindestens ein Ende des zweiten Schutzelements (9) in einer der mindestens zwei Nichtbiegeflächen (NBA1, NBA2) angeordnet ist oder zwei Enden des zweiten Schutzelements (9) jeweils in den mindestens zwei Nichtbiegeflächen (NBA1, NBA2) angeordnet sind.

4. Anzeigevorrichtung nach einem der vorhergehenden Ansprüche, wobei das erste Schutzelement (8) und das zweite Schutzelement (9) von einer Seitenoberfläche zur weiteren Seitenoberfläche des Biegebereichs (BA) verlaufen und das dritte Schutzelement mindestens eine Seitenoberfläche des Biegebereichs (BA) abdeckt.

5. Anzeigevorrichtung nach einem der vorhergehenden Ansprüche, wobei das zweite Schutzelement (9) und das dritte Schutzelement (11) aus verschiedenen Materialien hergestellt sind.

6. Anzeigevorrichtung nach einem der vorhergehenden Ansprüche, wobei das zweite Schutzelement (9) ein schwarzes Material enthält oder daraus gebildet ist.

7. Anzeigevorrichtung nach einem der vorhergehenden Ansprüche, wobei das dritte Schutzelement (11) ein ultraviolettdurchlässiges Material enthält oder daraus gebildet ist.

8. Anzeigevorrichtung nach einem der vorhergehenden Ansprüche, wobei der Zugmodul des dritten Schutzelements (11) kleiner als der Zugmodul des ersten Schutzelements (8) ist oder der Zugmodul des dritten Schutzelements (11) größer als der Zugmodul des ersten Schutzelements (8) ist.

9. Anzeigevorrichtung nach einem der vorhergehenden Ansprüche, wobei das zweite Schutzelement (9) ein Klebematerial enthält und/oder Klebeeigenschaften aufweist.

10. Anzeigevorrichtung nach einem der vorhergehenden Ansprüche, die ferner einen Polarisator (6) an der Anzeigetafel (1) umfasst, wobei der Polarisator (6) ein Ende des ersten Schutzelements (8) und ein Ende des zweiten Schutzelements (9) berührt.

11. Anzeigevorrichtung nach einem der vorhergehenden Ansprüche, die ferner eine flexible dünne Schicht (2) umfasst, die von einem Ende des ersten Schutzelements (8) und einem Ende des zweiten Schutzelements (9) beabstandet ist.

12. Anzeigevorrichtung nach einem der vorhergehenden Ansprüche, wobei das dritte Schutzelement (11) die Biegefläche (BA) und einen Abschnitt der mindestens zwei Nichtbiegeflächen (NBA1, NBA2) abdeckt.

13. Anzeigevorrichtung nach einem der vorhergehenden Ansprüche, die ferner ein Frontoberflächenelement (7) umfasst, das auf einer Vorderseite der Anzeigetafel (1) angeordnet ist und das dritte Schutzelement (11) berührt.

14. Anzeigevorrichtung nach einem der vorhergehenden Ansprüche, wobei die Anzeigetafel (1) eine flexible Anzeigetafel ist und/oder
die Anzeigetafel ferner (1) eine Schicht lichtemittierender Elemente (500) enthält, wobei die Schicht lichtemittierender Elemente ein organisches Material oder ein anorganisches Material enthält.

15. Anzeigevorrichtung nach einem der vorhergehenden Ansprüche, die ferner ein Trägerelement (4) enthält, das auf einer Rückseite der Anzeigetafel (1) angeordnet ist,
wobei mindestens ein Ende des zweiten Schutzelements (9) mit dem Trägerelement (4) überlappt und/oder dann, wenn die Anzeigetafel (1) gebogen ist, das Trägerelement (4) zwischen den zwei Enden des zweiten Schutzelements (9), die jeweils in den mindestens zwei Nichtbiegeflächen (NBA1, NBA2) angeordnet sind, eingeklemmt ist.

## Revendications

1. Appareil d'affichage comportant :
un panneau d'affichage (1) incluant au moins deux zones de non-pliage (NBA1, NBA2) et une zone de pliage (BA) entre deux des au moins deux zones de non-pliage ;
un premier élément de protection (8) disposé sur au moins la zone de pliage (BA) ;
un deuxième élément de protection (9) disposé sur le premier élément de protection (8) ; et
un troisième élément de protection (11) disposé sur le deuxième élément de protection (9),
dans lequel le premier élément de protection (8), le deuxième élément de protection (9) et le troisième élément de protection (11) sont disposés dans cet ordre de l'intérieur vers l'extérieur de l'appareil d'affichage,
dans lequel le premier élément de protection (8) inclut ou est composé de résine,
dans lequel le troisième élément de protection (11) inclut ou est composé de résine,
dans lequel le deuxième élément de protection (9) inclut ou est composé d'un matériau bloqueur d'ultraviolet et est agencé et/ou configuré pour bloquer une projection de lumière ultraviolette vers le premier élément de protection (8),
dans lequel un module d'élasticité en traction du premier élément de protection (8) est différent d'un module d'élasticité en traction du troisième élément de protection (11).

2. Dispositif d'affichage selon la revendication 1, dans lequel le deuxième élément de protection (9) recouvre au moins une extrémité du premier élément de protection (8), en particulier une surface latérale de la au moins une extrémité du premier élément de protection (8).

3. Appareil d'affichage selon l'une quelconque des revendications précédentes, dans lequel une extrémité du deuxième élément de protection (9) est en contact avec au moins une partie du panneau d'affichage (1), et/ou dans lequel au moins une extrémité du deuxième élément de protection (9) est disposée dans l'une des au moins deux zones de non-pliage (NBA1, NBA2) ou deux extrémités du deuxième élément de protection (9) sont disposées dans les au moins deux zones de non-pliage (NBA1, NBA2), respectivement.

4. Appareil d'affichage selon l'une quelconque des revendications précédentes, dans lequel le premier élément de protection (8) et le deuxième élément de protection (9) s'étendent d'une surface latérale à l'autre surface latérale de la zone de pliage (BA), et le troisième élément de protection recouvre au moins une surface latérale de la zone de pliage (BA).

5. Appareil d'affichage selon l'une quelconque des revendications précédentes, dans lequel le deuxième élément de protection (9) et le troisième élément de protection (11) sont constitués de matériaux différents.

6. Appareil d'affichage selon l'une quelconque des revendications précédentes, dans lequel le deuxième élément de protection (9) inclut ou est composé d'un matériau noir.

7. Appareil d'affichage selon l'une quelconque des revendications précédentes, dans lequel le troisième élément de protection (11) inclut ou est composé d'un matériau transmetteur d'ultraviolet.

8. Appareil d'affichage selon l'une quelconque des revendications précédentes, dans lequel le module d'élasticité en traction du troisième élément de protection (11) est inférieur au module d'élasticité en traction du premier élément de protection (8), ou le module d'élasticité en traction du troisième élément de protection (11) est supérieur au module d'élasticité en traction du premier élément de protection (8).

9. Appareil d'affichage selon l'une quelconque des revendications précédentes, dans lequel le deuxième élément de protection (9) inclut un matériau adhésif et/ou présente des propriétés adhésives.

10. Appareil d'affichage selon l'une quelconque des revendications précédentes, comportant en outre un polariseur (6) sur le panneau d'affichage (1), le polariseur (6) étant en contact avec une extrémité du premier élément de protection (8) et une extrémité du deuxième élément de protection (9).

11. Appareil d'affichage selon l'une quelconque des revendications précédentes, comportant en outre un film souple (2) espacé d'une extrémité du premier élément de protection (8) et d'une extrémité du deuxième élément de protection (9).

12. Appareil d'affichage selon l'une quelconque des revendications précédentes, dans lequel le troisième élément de protection (11) recouvre la zone de pliage (BA) et une portion des au moins deux zones de non-pliage (NBA1, NBA2).

13. Appareil d'affichage selon l'une quelconque des revendications précédentes, comportant en outre un élément de surface avant (7) disposé sur un côté avant du panneau d'affichage (1) et en contact avec le troisième élément de protection (11).

14. Appareil d'affichage selon l'une quelconque des revendications précédentes, dans lequel le panneau d'affichage (1) est un panneau d'affichage souple, et/ou
dans lequel le panneau d'affichage (1) inclut en outre une couche d'élément électroluminescent (500), la couche d'élément électroluminescent incluant un matériau organique ou un matériau inorganique.

15. Appareil d'affichage selon l'une quelconque des revendications précédentes, incluant en outre un élément de support (4) disposé sur un côté arrière du panneau d'affichage (1),
dans lequel au moins une extrémité du deuxième élément de protection (9) chevauche l'élément de support (4) et/ou, lorsque le panneau d'affichage (1) est plié, l'élément de support (4) est pris en sandwich entre les deux extrémités du deuxième élément de protection (9) disposées dans les au moins deux zones de non-pliage (NBA1, NBA2), respectivement.
